(19) Europäisches Patentamt
European Patent Office
Office européen des brevets

(11) **EP 4 739 033 A1**

(12) **EUROPEAN PATENT APPLICATION**

(43) Date of publication:
**06.05.2026 Bulletin 2026/19**

(21) Application number: **25212419.3**

(22) Date of filing: **30.10.2025**

(51) International Patent Classification (IPC):
***H10D 86/40*** *(2025.01)* ***H10D 86/60*** *(2025.01)*
***H10K 59/131*** *(2023.01)* ***G09G 3/32*** *(2016.01)*

(52) Cooperative Patent Classification (CPC):
**H10K 59/131; H10D 86/441; H10D 86/60;**
G09G 3/2081; G09G 3/32; G09G 2300/0426

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **01.11.2024 CN 202411554497**

(71) Applicant: **Tianma Advanced Display Technology
Institute
(Xiamen) Co., Ltd.
361101 Xiamen (CN)**

(72) Inventors:
• **MENG, Fanqing**
361101 Xiamen, Fujian (CN)
• **JIA, Zhenyu**
361101 Xiamen, Fujian (CN)
• **YANG, Bo**
361101 Xiamen, Fujian (CN)

(74) Representative: **Germain Maureau
12, rue Boileau
69006 Lyon (FR)**

(54) **DISPLAY PANEL AND DISPLAY DEVICE**

(57) The disclosure provides a display panel and a display device. The display panel includes a substrate; an active layer located on a side of the substrate; multiple metal layers located on a side of the active layer away from the substrate, the multiple metal layers including a first metal layer and a second metal layer, the first metal layer including a physical part and a plurality of openings, the second metal layer including a physical part and a plurality of openings; and a first shielding area, where at least a portion of the active layer is located within the first shielding area, and in a direction perpendicular to a plane where the substrate is located, at least one of the physical part of the first metal layer and the physical part of the second metal layer covers the first shielding area.

FIG. 2

EP 4 739 033 A1

**Description**

TECHNICAL FIELD

The present disclosure generally relates to the field of display technology, and in particular to a display panel and a display device.

BACKGROUND

Light emitting diode (LED) display panels, such as micro-LED display panels and mini-LED display panels, have many advantages such as self-luminescence, low driving voltage, high luminous efficiency, short response time, high clarity and contrast, etc. LED display panels thus have gradually become a research hotspot in the field of display technology.

When preparing a light emitting diode display panel, a light emitting diode needs to be fixed to an array substrate by laser bonding technology. Since the array substrate includes an active layer, when laser bonding the light emitting diode, it is easy to affect at least part of the active layer, thereby affecting the performance of a thin film transistor that includes the at least part of the active layer.

SUMMARY

To solve the above technical problems, the embodiments of the present disclosure provide a display panel and a display device to avoid affecting at least part of the active layer in the array substrate when laser bonding light emitting diodes, thereby avoiding affecting the performance of a thin film transistor that includes at least part of the active layer.

In one aspect, an embodiment of the present disclosure provides a display panel, and the display panel includes: a substrate; an active layer located on a side of the substrate; multiple metal layers located on a side of the active layer away from the substrate, the multiple metal layers including a first metal layer and a second metal layer, the first metal layer including a physical part and multiple openings of the first metal layer, the second metal layer including a physical part and multiple openings of the second metal layer; and a first shielding area, where at least a part of the active layer is located within the first shielding area, and in a direction perpendicular to a plane where the substrate is located, at least one of the physical part of the first metal layer and the physical part of the second metal layer covers the first shielding area.

In an embodiment, an insulating layer is provided between the first metal layer and the second metal layer, and the insulating layer is an organic material layer.

In an embodiment, the display panel further includes: multiple pixel circuits, where the active layer includes a first active portion, the multiple pixel circuits includes the first active portion, and the first active portion is located within the first shielding area.

In an embodiment, the physical part of the first metal layer includes a first power supply structure, and the first power supply structure is configured to provide a first power supply voltage; the physical part of the second metal layer includes a second power supply structure, and the second power supply structure is configured to provide a second power supply voltage; and the display panel includes multiple light emitting diodes, the first power supply structure is electrically connected to the multiple pixel circuits, the multiple pixel circuits is electrically connected to first electrodes of the multiple light emitting diodes, and the second power supply structure is electrically connected to second electrodes of the multiple light emitting diodes.

In an embodiment, a pixel circuit of the multiple pixel circuits includes a pulse width module and an amplitude module, and the first power supply structure is electrically connected to the amplitude module of the pixel circuit of the multiple pixel circuits.

In an embodiment, at least two pixel circuits of the multiple pixel circuits form a pixel circuit group, and first active portions of the pixel circuit group are located in the first shielding area; the pixel circuit group is arranged in rows along a first direction, and multiple rows of pixel circuit groups are arranged along a second direction, the first direction and the second direction intersect, and the first direction and the second direction are parallel to the plane where the substrate is located; in the direction perpendicular to the plane where the substrate is located, the first power supply structure at least partially overlaps with four pixel circuit groups including two adjacent rows of pixel circuit groups and two adjacent columns of pixel circuit groups of the first power supply structure; and in the direction perpendicular to the plane where the substrate is located, the second power supply structure at least partially overlaps with four pixel circuit groups including two adjacent rows of pixel circuit groups and two adjacent columns of pixel circuit groups the second power supply structure.

In an embodiment, the multiple openings of the first metal layer includes multiple first openings; the multiple openings of the second metal layer includes multiple second openings; and in the first shielding area, first openings of the multiple first openings and second openings of the multiple second openings do not overlap in the direction perpendicular to the plane where the substrate is located.

In an embodiment, in at least a portion of the first shielding area, first openings of the multiple first openings are arranged in columns along the second direction, multiple columns of first openings of the multiple first openings are arranged along the first direction, first openings of the multiple first openings in alternate columns overlap along the first direction, and first openings of the multiple first openings in adjacent columns overlap along the first direction or the first openings of the multiple first openings in adjacent columns at least partially do not overlap along the first direction; and/or in at least a portion of the first shielding area, second openings of the multiple second openings are arranged in columns along the second direction, multiple columns of the second openings of the multiple second openings are arranged along the first direction, second openings of the multiple second openings in alternate columns overlap along the first direction, and second openings of the multiple second openings in adjacent columns overlap along the first direction or the second openings of the multiple second openings in adjacent columns at least partially do not overlap along the first direction.

In an embodiment, in at least a portion of the first shielding area, first openings of the multiple first openings are arranged in columns along the second direction, multiple columns of first openings of the multiple first openings are arranged along the first direction, first openings of the multiple first openings in adjacent columns overlap along the first direction, and first openings of the multiple first openings in alternate columns overlap along the first direction; and/or in at least a portion of the first shielding area, second openings of the multiple second openings are arranged in columns along the second direction, multiple columns of second openings of the multiple second openings are arranged along the first direction, second openings of the multiple second openings in adjacent columns overlap along the first direction, and second openings of the multiple second openings in alternate columns overlap along the first direction.

In an embodiment, the physical part of the second metal layer further includes a first auxiliary electrode, and a third opening is provided between the first auxiliary electrode and the second power structure; the first auxiliary electrode is electrically connected to the multiple pixel circuits, and the first auxiliary electrode is electrically connected to the first electrodes of the multiple light emitting diodes; and the first auxiliary electrode and a second power structure between two adjacent first auxiliary electrodes are provided with multiple fourth openings, and an area of a fourth opening of the multiple fourth openings is smaller than an area of a second opening of the multiple second openings.

In an embodiment, in the direction perpendicular to the plane where the substrate is located, multiple fifth openings are provided at a portion where the first power structure overlaps with the first auxiliary electrode and the second power structure between two adjacent first auxiliary electrodes; the multiple fifth openings are arranged in columns along the second direction, multiple columns of fifth openings of the multiple fifth openings are arranged along the first direction, fifth openings of the multiple fifth openings in adjacent columns overlap along the first direction, and fifth openings of the multiple fifth openings in alternate columns overlap along the first direction; and orthographic projections of the fourth openings of the multiple fourth openings on the first metal layer are alternately arranged with the fifth openings of the multiple fifth openings along the second direction.

In an embodiment, the physical part of the first metal layer further includes a second auxiliary electrode, and a sixth opening is provided between the second auxiliary electrode and the first power structure; and in the direction perpendicular to the plane where the substrate is located, the first auxiliary electrode and the second auxiliary electrode at least partially overlap, the first auxiliary electrode and the second auxiliary electrode are electrically connected, and the second auxiliary electrode is electrically connected to the multiple pixel circuits.

In an embodiment, the sixth opening is located outside the first shielding area; or the sixth opening is located within the first shielding area, and in the direction perpendicular to the plane where the substrate is located, the sixth opening does not overlap with the active layer.

In an embodiment, at least two light emitting diodes of the multiple light emitting diodes form a light emitting element group, and one pixel circuit group is electrically connected to one light emitting element group; in the direction perpendicular to the plane where the substrate is located, the pixel circuit group and a light emitting element group electrically connected with the pixel circuit group at least partially do not overlap along the second direction; and in the direction perpendicular to the plane where the substrate is located, the first auxiliary electrode and the second auxiliary electrode overlap in the first shielding area, the second auxiliary electrode and the sixth opening are at least partially located outside the first shielding area, and the sixth opening does not overlap with the active layer.

In an embodiment, the first power structure includes a first connection portion, and the first connection portion is electrically connected to the multiple pixel circuits; and at least a portion of the first connecting portion protrudes toward an opening of the first metal layer.

In an embodiment, in the first shielding area, a minimum distance d between an orthographic projection of an opening of the second metal layer on the first metal layer and an opening of the first metal layer satisfies:

$$d \geq \frac{X1 + X2}{2} + \sqrt{Y^2 + H^2} \, ,$$

where, X1 is a line width difference between a design pattern and an actual production pattern of the first metal layer, X2 is a line width difference between a design pattern and an actual production pattern of the second metal layer, Y is a fitting accuracy between the first metal layer and the second metal layer, and H is a thickness of the insulating layer between the first metal layer and the second metal layer.

In an embodiment, a wiring area is provided on at least one side of the pixel circuit group along the first direction, and the wiring area includes a signal line extending along the second direction; the multiple openings of the first metal layer further includes multiple seventh openings, and an area of a seventh opening of the multiple seventh openings is greater than an area of a first opening of the multiple first openings; and in the wiring area, the multiple seventh openings are arranged along the second direction.

In an embodiment, along the second direction, the multiple seventh openings and the multiple first openings are alternatingly arranged.

In an embodiment, a wiring area is provided on at least one side of the pixel circuit group along the first direction, and the wiring area includes a signal line extending along the second direction; the multiple openings of the second metal layer further includes multiple eighth openings, and an area of an eighth opening of the multiple eighth openings is greater than an area of a second opening of the multiple second openings; and in the wiring area, the multiple eighth openings are arranged along the second direction.

In an embodiment, along the second direction, the multiple eighth openings and the multiple the second openings are alternatingly arranged.

In an embodiment, a wiring area is provided on at least one side of the pixel circuit group along the first direction, and the wiring area includes a signal line extending along the second direction; the multiple openings of the first metal layer further includes multiple seventh openings, and an area of a seventh opening of the multiple seventh openings is greater than an area of a first opening of the multiple first openings; in the wiring area, the multiple seventh openings are arranged along the second direction; the multiple openings of the second metal layer further includes multiple eighth openings, an area of an eighth opening of the multiple eighth openings is greater than an area of a second opening of the multiple second openings; in the wiring area, the multiple eighth openings are arranged along the second direction; orthographic projections of the multiple eighth openings on the first metal layer and the multiple seventh openings are alternatingly arranged along the second direction.

In an embodiment, along the second direction, the multiple seventh openings and the multiple first openings are alternatingly arranged; along the second direction, the multiple eighth openings and the multiple the second openings are alternatingly arranged; and an orthographic projection of an eighth opening of the multiple eighth openings on the first metal layer overlaps with multiple first openings between two adjacent seventh openings of the multiple seventh openings, and/or an orthographic projection of a seventh opening of the multiple seventh openings on the second metal layer overlaps with multiple second openings between two adjacent eighth openings of the multiple eighth openings.

In an embodiment, the display panel includes a driving circuit, and the driving circuit includes a multi-stage cascaded shift register circuit; and the active layer includes a second active portion, the shift register circuit includes the second active portion, and the second active portion is located within the first shielding area.

In an embodiment, the display panel includes multiple pixel circuits, and the shift register circuit is located between the multiple pixel circuits; or the display panel includes multiple light emitting diodes, and in the direction perpendicular to the plane where the substrate is located, the shift register circuit and the multiple light emitting diodes overlap.

In another aspect, an embodiment of the present disclosure provides a display device, the display device includes the display panel according to any one of the aforementioned embodiments.

Other features of the present disclosure and advantages thereof will become apparent from the following detailed description of exemplary embodiments of the present disclosure with reference to the accompanying drawings. Other embodiments in the summary are as disclosed in the claims as appended.

BRIEF DESCRIPTION OF THE DRAWINGS

In order to more clearly illustrate the technical solution in the embodiments of the present disclosure or in the existing technologies, the drawings essential to understanding the disclosed embodiments or the description of the existing technologies will be briefly introduced below. Apparently, the drawings provided below are only some embodiments of the present disclosure. For a person skilled in the art, other drawings may be obtained based on these drawings without making creative efforts.

The structures, proportions, sizes, etc. shown in the drawings of this specification are only used to match the contents disclosed in the specification for people familiar with this technology to understand and read, and are not used to limit the restrictive conditions that may be implemented in the present disclosure. Therefore, they have no technical substantive significance. Any structural modification, change in proportional relationship or adjustment of size should still fall within the scope of the technical content disclosed in the present disclosure without affecting the effects and purposes that may be achieved by the present disclosure.

FIG. 1 is a schematic diagram of a partial cross-sectional structure of an array substrate in a display panel, in accordance with an embodiment of the present disclosure;

FIG. 2 is a schematic diagram of a partial layout structure of a display panel, in accordance with an embodiment of the present disclosure;

FIG. 3 is a schematic diagram of the layout structure of the active layer q in FIG. 2;

FIG. 4 is a schematic diagram of the layout structure of the first metal layer M3 in FIG. 2;

FIG. 5 is a schematic diagram of the layout structure of the second metal layer M4 in FIG. 2;

FIG. 6 is a schematic diagram showing a short circuit between the first metal layer M3 and the second metal layer M4 caused by damage to the insulating layer PLN between the two metal layers;

FIG. 7 is a schematic diagram of a circuit structure of a pixel circuit 110 in a display panel, in accordance with an embodiment of the present disclosure;

FIG. 8 is a timing diagram of the pixel circuit 110 shown in FIG. 7;

FIG. 9 is a schematic diagram of a partial cross-sectional structure of a display panel, in accordance with an embodiment of the present disclosure;

FIG. 10 is a schematic diagram of a partial layout structure of another display panel, in accordance with an embodiment of the present disclosure;

FIG. 11 is a schematic diagram of the layout structure of the active layer q in FIG. 10;

FIG. 12 is a schematic diagram of the layout structure of the first metal layer M3 in FIG. 10;

FIG. 13 is a schematic diagram of the layout structure of the second metal layer M4 in FIG. 10;

FIG. 14 is a schematic diagram of the stacking of the layout structure of the first metal layer M3 in FIG. 4 and the layout structure of the second metal layer M4 in FIG. 5;

FIG. 15 is a schematic diagram of a partially enlarged view of area CC1 in a first shielding area CC in a display panel, in accordance with an embodiment of the present disclosure;

FIG. 16 is a schematic diagram of another partially enlarged view of area CC1 in a first shielding area CC in a display panel, in accordance with an embodiment of the present disclosure;

FIG. 17 is a schematic diagram of a partial layout structure of another display panel, in accordance with an embodiment of the present disclosure;

FIG. 18 is a schematic diagram of the layout structure of the active layer q in FIG. 17;

FIG. 19 is a schematic diagram of the layout structure of the first metal layer M3 in FIG. 17;

FIG. 20 is a schematic diagram of the layout structure of the second metal layer M4 in FIG. 17;

FIG. 21 is a schematic diagram of a partial cross-sectional structure of the first metal layer M3 and the second metal layer M4 in a display panel, in accordance with an embodiment of the present disclosure;

FIG. 22a is a schematic diagram of a cross-sectional structure of a design pattern of the first metal layer M3 and the second metal layer M4 in a display panel, in accordance with an embodiment of the present disclosure;

FIG. 22b is a schematic diagram of a cross-sectional structure of an actual pattern of the first metal layer M3 and the second metal layer M4 in a display panel, in accordance with an embodiment of the present disclosure;

FIG. 23a is a schematic diagram of a cross-sectional structure of another design pattern of the first metal layer M3 and the second metal layer M4 in a display panel, in accordance with an embodiment of the present disclosure;

FIG. 23b is a schematic diagram of a cross-sectional structure of another actual pattern of the first metal layer M3 and the second metal layer M4 in a display panel, in accordance with an embodiment of the present disclosure;

FIG. 24 is a schematic diagram of a partial layout stacking structure of an active layer q, a metal layer M1 and a metal layer M2 in a display panel, in accordance with an embodiment of the present disclosure;

FIG. 25 is a schematic diagram of a partially enlarged view of the first metal layer M3 and the second metal layer M4 in the wiring area FF in a display panel, in accordance with an embodiment of the present disclosure;

FIG. 26 is a schematic diagram of a partial layout structure of another display panel, in accordance with an embodiment of the present disclosure;

FIG. 27 is a schematic diagram of the layout structure of the active layer q in FIG. 26;

FIG. 28 is a schematic diagram of the layout structure of the first metal layer M3 in FIG. 26;

FIG. 29 is a schematic diagram of the layout structure of the second metal layer M4 in FIG. 26;

FIG. 30 is a schematic structural diagram of a display device, in accordance with an embodiment of the present disclosure; and

FIG. 31 is a schematic structural diagram of another display device, in accordance with an embodiment of the present disclosure.

## DETAILED DESCRIPTION

In conjunction with the drawings in the embodiments of the present disclosure, the following will clearly and thoroughly describe the technical solutions in the embodiments of the present disclosure. Apparently, the described embodiments are only part of the embodiments of the present disclosure, not all of the embodiments. Based on the embodiments in the present disclosure, all other embodiments obtained by a person skilled in the art without creative work are within the scope of protection of this disclosure.

In the following description, many specific details are set forth to facilitate a full understanding of the present disclosure, but the present disclosure may also be implemented in other ways different from those described herein, and those skilled in the art may make similar generalizations without violating the connotation of the present disclosure. Therefore, the present disclosure is not limited to the specific embodiments disclosed below. It should be noted that embodiments of the present disclosure and the features in embodiments may be combined with each other if there is no conflict.

As described in the background section, when preparing a light emitting diode display panel, a light emitting diode needs to be fixed to the array substrate by laser bonding technology. However, the array substrate includes an active layer, and when laser bonding the light emitting diode, it is easy to affect at least part of the active layer, thereby affecting the performance of a thin film transistor that includes at least part of the active layer.

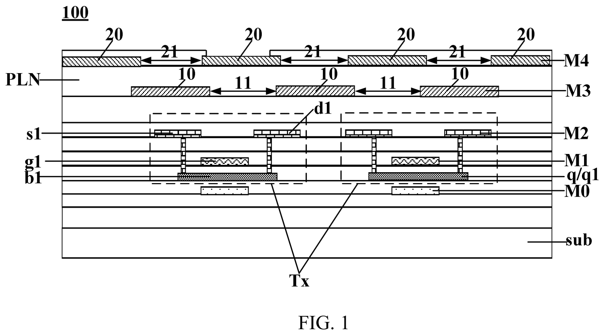

In view of this, an embodiment of the present disclosure provides a display panel, which includes an array substrate and a light emitting diode located on the array substrate. FIG. 1 shows a schematic diagram of a partial cross-sectional structure of an array substrate 100 in a display panel, in accordance with an embodiment of the present disclosure. As shown in FIG. 1, the array substrate 100 in the display panel includes a substrate (shown as "sub" in the drawings), an active layer q located on one side of the substrate, and multiple metal layers located on the side of the active layer q away from the substrate. The multiple metal layers include, for example, a metal layer M1, a metal layer M2, a metal layer M3, and a metal layer M4 arranged in sequence in a direction away from the substrate. A metal layer such as a metal layer M0 may also be provided on the side of the active layer q facing the substrate. The multiple metal layers on the side of the active layer q away from the substrate include a first metal layer M3 and a second metal layer M4, where the first metal layer M3 includes a physical part 10 and a plurality of openings 11, and the second metal layer M4 also includes a physical part 20 and a plurality of openings 21. The physical part refers to the actual physical presence and functional portion of a metal layer, as opposed to the openings within the layer. Specifically, the physical part means the solid and continuous section of a metal layer that provides electrical conductivity and structural support, and this part of the metal layer is used to create electrical connections, provide power supply paths, and cover certain areas for protection, such as the first shielding area.

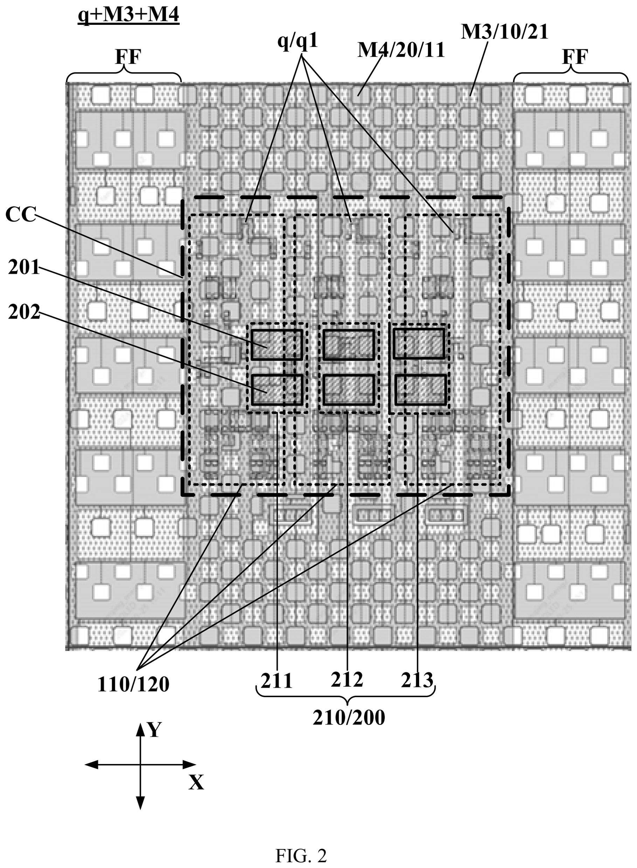

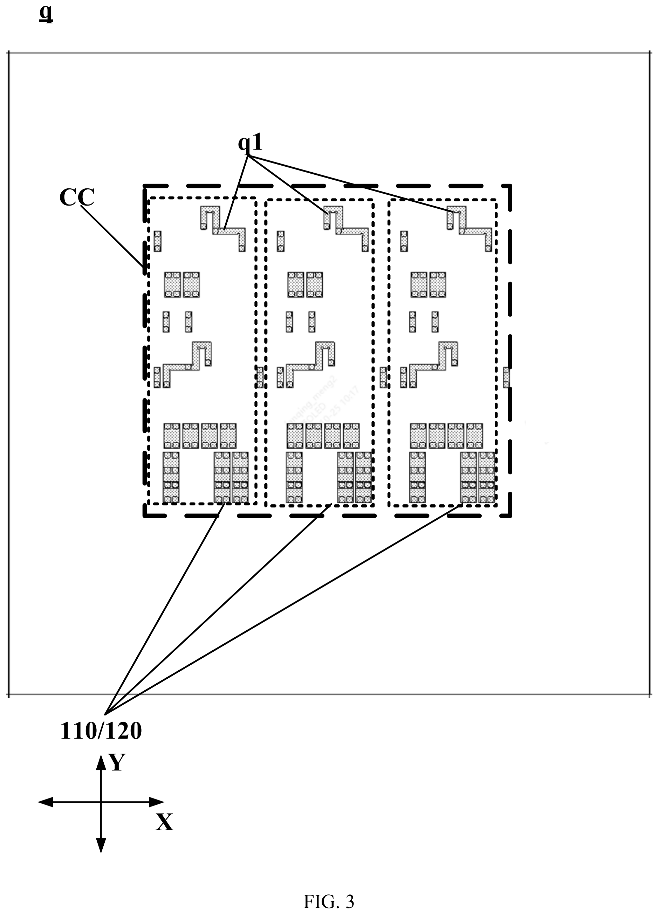

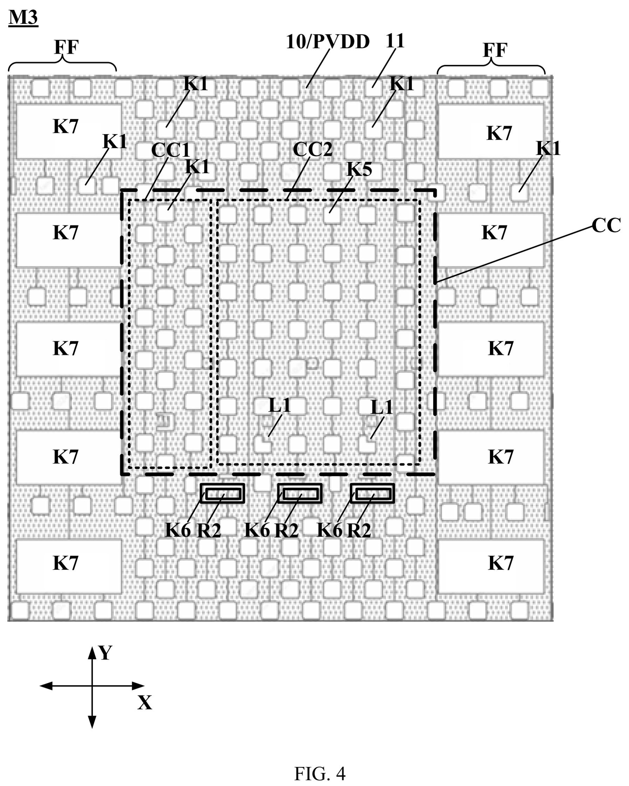

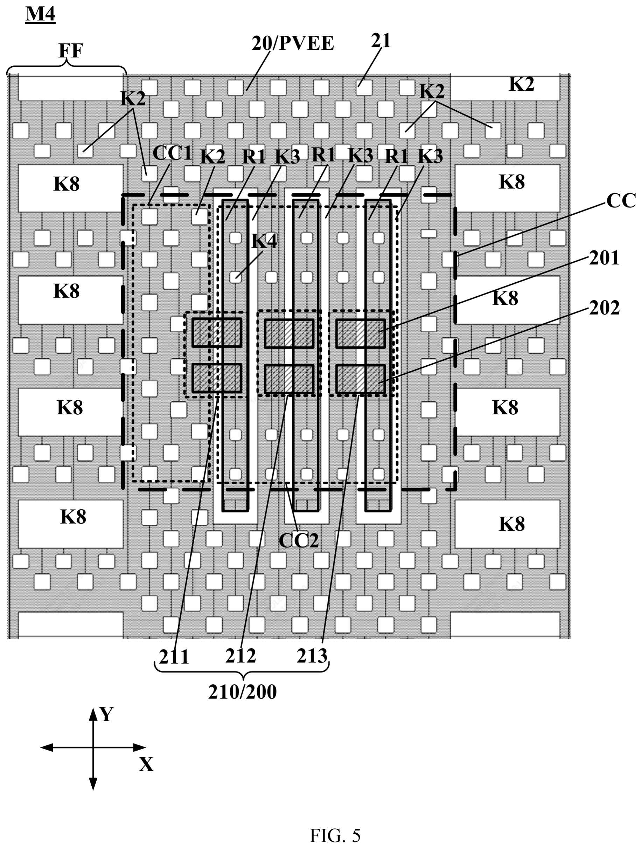

FIG. 2 shows a schematic diagram of a partial layout structure of a display panel, in accordance with an embodiment of the present disclosure. For the sake of clarity, FIG. 2 only shows the layout structure of the active layer q, the layout structure of the first metal layer M3, and the layout structure of the second metal layer M4. FIG. 3 shows a schematic diagram of the layout structure of the active layer q in FIG. 2, FIG. 4 shows a schematic diagram of the layout structure of the first metal layer M3 in FIG. 2, and FIG. 5 shows a schematic diagram of the layout structure of the second metal layer M4 in FIG. 2. As shown in FIGS. 2-5, the display panel includes a first shielding area CC, where at least part of the active layer q is located in the first shielding area CC. In a direction perpendicular to a plane where the substrate is located, at least one of the physical part 10 of the first metal layer M3 and the physical part 20 of the second metal layer M4 covers the first shielding area CC. That is, at least one of the physical part 10 of the first metal layer M3 and the physical part 20 of the second metal layer M4 completely shields the first shielding area CC.

It may be understood that, in a direction perpendicular to the plane where the substrate is located, at least one of the physical part 10 of the first metal layer M3 and the physical part 20 of the second metal layer M4 covers the first shielding area CC. In other words, in an embodiment, the physical part 10 of the first metal layer M3 covers the first shielding area CC, or the physical part 20 of the second metal layer M4 covers the first shielding area CC, or the physical part 10 of the first metal layer M3 and the physical part 20 of the second metal layer M4 jointly cover the first shielding area CC.

In the display panel provided by the embodiments of the present disclosure, since at least part of the active layer q is located in the first shielding area CC, and the first metal layer M3 and the second metal layer M4 are located on the side of the active layer q away from the substrate, the first shielding area CC is covered by at least one of the physical part 10 of the first metal layer M3 and the physical part 20 of the second metal layer M4, so that the active layer q in the first shielding area CC is covered by at least one of the physical part 10 of the first metal layer M3 and the physical part 20 of the second metal layer M4, thereby avoiding affecting the active layer q in the first shielding area CC when laser bonding a light emitting diode, and further avoiding affecting the performance of a thin film transistor that includes the active layer q in the first shielding area CC.

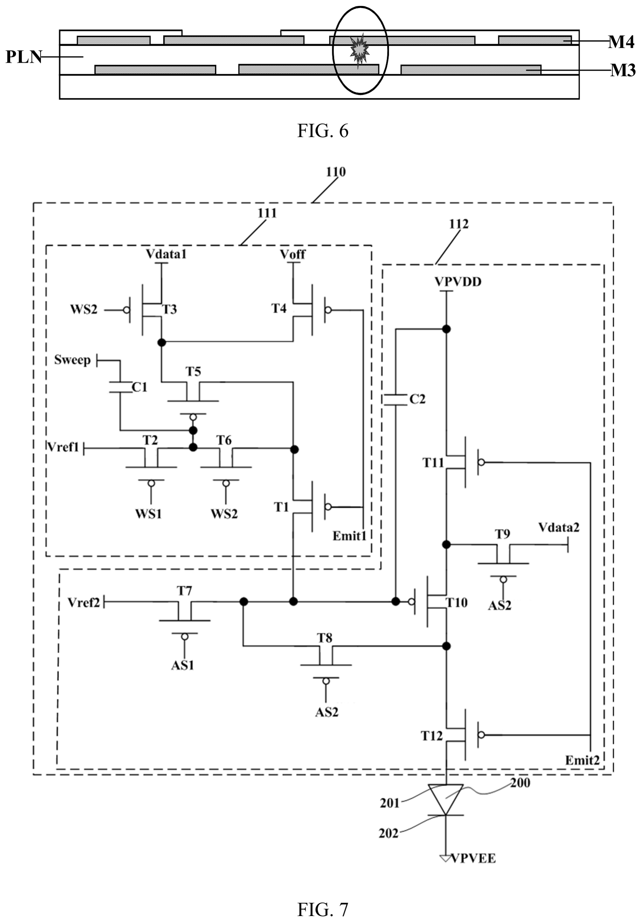

In addition, considering that in the actual process, arc discharge is prone to occur when a large area of metal is placed in a vacuum machine for patterning, the area of the physical part 10 of the first metal layer M3 and the area of the physical part 20 of the second metal layer M4 are subject to certain restrictions. Furthermore, considering that in a direction perpendicular to the plane where the substrate is located, if the overlapping area of the physical part 10 of the first metal layer M3 and the physical part 20 of the second metal layer M4 is relatively large, as shown in FIG. 6, when the insulating layer PLN between the first metal layer M3 and the second metal layer M4 is damaged, it is easy to cause a short circuit between the two metal layers. Therefore, as shown in FIGS. 1, 2 and 4-5, in the first metal layer M3, a plurality of openings 11 are formed to reduce the area of the physical part 10 of the first metal layer M3, and a plurality of openings 21 are formed in the second metal layer M4 to reduce the area of the physical part 20 of the second metal layer M4, thereby reducing the risk of arc discharge when the first metal layer M3 and the second metal layer M4 are subjected to patterning in a vacuum machine. The overlapping area of the physical part 10 of the first metal layer M3 and the physical part 20 of the second metal layer M4 in a direction perpendicular to the plane of the substrate may also be reduced, thereby reducing the risk of short circuit between the first metal layer M3 and the second metal layer M4 when the insulating layer between the first metal layer M3 and the second metal layer M4 is damaged.

Different metal layers in the display panel are isolated by an insulating layer, which not only serves as an isolation layer, but also as a protection and support layer. In an embodiment, as shown in FIG. 1, there is an insulating layer PLN between the first metal layer M3 and the second metal layer M4, and the insulating layer PLN is an organic material layer. That is, the insulating layer PLN is an organic insulating layer. Alternatively, the insulating layer PLN may also be an inorganic material layer.

Compared with an inorganic material layer as an insulating layer, an organic material layer as an insulating layer usually has a lower manufacturing cost. Moreover, the organic material layer usually has good chemical stability and physical properties, may resist the erosion of environmental factors such as moisture and oxygen, and is beneficial to extending the service life of the display panel. The organic material layer also has good flexibility and customization. However, the organic insulating layer will release gas in some high-temperature processes, and thus gas release design is required. In the display panel provided in the embodiments of the present disclosure, a plurality of openings 11 are formed in the first metal layer M3 and a plurality of openings 21 are formed in the second metal layer M4, which is beneficial to the gas release of the organic insulating layer between the first metal layer M3 and the second metal layer M4.

It is to be noted that, as shown in FIG. 2, the array substrate 100 in the display panel includes a plurality of pixel circuits 110, and the pixel circuits 110 are configured to drive the light emitting diodes 200 to emit light. In an embodiment, FIG. 7 shows a schematic diagram of a circuit structure of a pixel circuit 110. As shown in FIG. 7, the pixel circuit 110 may include a pulse width module 111 controlled by pulse width modulation (PWM) and an amplitude module 112 controlled by pulse amplitude modulation (PAM), so as to achieve the best performance of the light emitting efficiency and the color deviation of the viewing angle of the driven light emitting diode 200. The pulse width module 111 in the pixel circuit 110 may include 6 thin film transistors (T1-T6) and a capacitor (C1), receiving scanning signals WS1 and WS2, data signal Vdata1, light control signal Emit1, reference signal Vref1, turn-off voltage Voff and pulse width control voltage Sweep, and is configured to control the light emission duration of the light emitting diode 200. The amplitude module 112 in the pixel circuit 110 may include 6 thin film transistors (T7-T12) and a capacitor (C2), receiving scanning signals AS1 and AS2, data signal Vdata2, light control signal Emit2, reference signal Vref2, first power supply voltage VPVDD and second power supply voltage VPVEE, and is configured to control the light emission intensity of the light emitting diode 200. The connection mode and access signals of each thin film transistor in the pixel circuit 110 are shown in FIG. 7, which will not be repeated.

Apparently, the pixel circuit 110 shown in FIG. 7 is only one type of pixel circuit in a light emitting diode display panel. In practical applications, the configuration of the pixel circuit may be selected based on requirements and is not limited to the circuit structure shown in FIG. 7.

In order to better understand the present disclosure, the working process of the pixel circuit 110 is described below by taking the thin film transistors T1 to T12 in FIG. 7 as P-type transistors that are turned on under a low-level signal as an example.

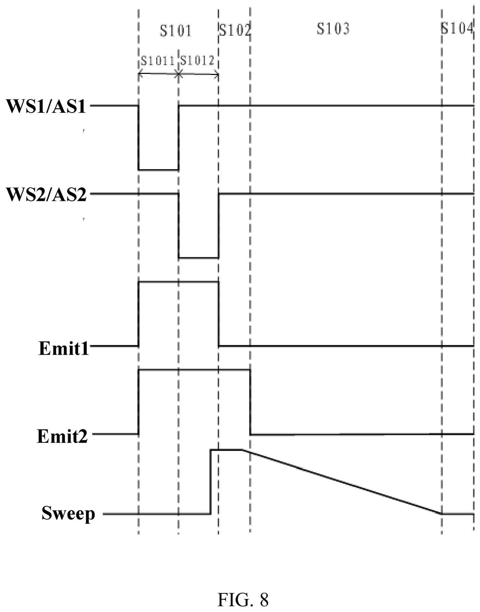

Referring to the timing diagram of FIG. 8, firstly, in the first stage S1011 of the signal generation stage S101, also referred to as the initialization stage, for the pulse width module 111, the scan signal WS1 is at a low level, the scan signal WS2 and the light emitting control signal Emit1 are at a high level, so that the transistor T2 is turned on, and the reference signal Vref1 is transmitted to the gate of the transistor T5, so that the gate T5 of the transistor is initialized. Similarly, for the amplitude module 112, the scan signal AS1 is at a low level, the scan signal AS2 and the light emitting control signal Emit2 are at a high level, so that the transistor T7 is turned on, and the reference signal Vref2 is transmitted to the gate of the transistor T10, so that the gate of the transistor T10 is initialized.

Secondly, in the second stage S1012 of the signal generation stage S101, for the pulse width module 111, the scan signal WS2 is at a low level, and the scan signal WS1 and the light emitting control signal Emit1 are at a high level. At this moment, the transistor T3, the transistor T5 and the transistor T6 are all turned on, forming a path from the data signal Vdata1 to the gate of the transistor T5, so as to pull up the voltage of the lower electrode of the capacitor C1 until the voltage of the lower plate of the capacitor C1 is pulled up to the point where the transistor T5 cannot be turned on, so that the first terminal of the transistor T1 is in a high impedance state and connected to a floating signal. Similarly, for the amplitude module 112, the scan signal AS2 is at a low level, the scan signal AS1 and the light emitting control signal Emit2 are at a high level. At this moment, the transistor T8, transistor T9 and transistor T10 are turned on, forming a path from the data signal Vdata2 to the gate of transistor T10 to increase the voltage of the lower plate of capacitor C2 until the voltage of the lower electrode of capacitor C2 is increased to the point where transistor T10 cannot be kept turned on. At this moment, the voltage of the lower plate of capacitor C2 is the corresponding voltage for controlling the luminous intensity of light emitting diode 200.

Next, in the control processing stage S102, for the pulse width module 111, the light control signal Emit1 is a low level signal, and the transistor T1 transmits the floating signal to the gate of the transistor T10 of the amplitude module 112. For the amplitude module 112, the light control signal Emit2 is still at a high level, so the transistors T11 and T12 are in the off state, so that the transistor T10 cannot be turned on, so as to avoid the fluctuation stage in which the transistor T1 initially transmits the floating signal to the gate of the transistor T10. In addition, due to the control of the pulse width control voltage Sweep at this moment, the voltage of the lower electrode of the capacitor C1 still cannot control the transistor T5 to turn on, and the path from the turn-off voltage Voff to the transistor T10 remains in the off state.

Then, in the light emitting control stage S103, for the amplitude module 112, the light emitting control signal Emit2 is a low-level signal, and the transistors T11, T10, and T12 are all turned on, forming a path from the first power supply voltage VPVDD to the light emitting diode 200 and the second power supply voltage VPVEE. The transistor T10 outputs a corresponding driving current to the light emitting diode 200 according to the signal of its gate and the signal of its first terminal, and the light emitting diode 200 emits light in response to the driving current. At this moment, for the pulse width module 111, due to the control of the pulse width control voltage Sweep, the voltage of the lower electrode of the capacitor C1 still cannot control the transistor T5 to turn on, and the path from the turn-off voltage Voff to the transistor T10 remains in the off state.

Afterwards, in the light-off stage S104, since the pulse width control voltage Sweep is a linearly decreasing voltage, in this stage, the pulse width control voltage Sweep decreases to a voltage at the lower plate of the capacitor C1 that may control the transistor T5 to turn on, thereby forming a path for the turn-off voltage Voff to the transistor T10, and the turn-off voltage Voff is transmitted to the gate of the transistor T10 to control the transistor T10 to turn off, thereby turning off the light emitting diode 200.

As shown in FIG. 1, a thin film transistor Tx (for example, any one of T1-T12) in the pixel circuit 110 includes an active portion b1, a gate g1, a source electrode s1 and a drain electrode d1, where the active portion b1 of the thin film transistor Tx is located in the active layer q. That is, as shown in FIGS. 2 and 3, the active layer q of the display panel includes a first active portion q1, and the pixel circuit 110 includes the first active portion q1. The first active portion q1 includes the active portion of each thin film transistor in the pixel circuit 110, and the first active portion q1 is located in the first shielding area CC. That is, the active portion of each thin film transistor in the pixel circuit 110 is located in the first shielding area CC. In this way, since at least one of the physical part 10 of the first metal layer M3 and the physical part 20 of the second metal layer M4 covers the first shielding area CC in a direction perpendicular to the plane where the substrate is located, that is, covers the active portion of each thin film transistor in the pixel circuit 110, it is possible to avoid affecting the active portion of each thin film transistor in the pixel circuit 110 when laser bonding the light emitting diode, thereby avoiding affecting the performance of the pixel circuit 110 and ensuring normal light emission of the light emitting diode.

It should be noted that in the present disclosure, for clarity of illustration, some drawings such as FIGS. 2 and 3 use the first active portion q1 in the pixel circuit 110 to represent the pixel circuit 110. It may be understood that the pixel circuit 110 also includes other film layer structures, which will not be repeated.

It should also be noted that, in the present disclosure, it is not limited to which metal layer the first metal layer M3 is located among the multiple metal layers on the side of the active layer q away from the substrate, nor is it limited to which metal layer the second metal layer M4 is located among the multiple metal layers on the side of the active layer q away from the substrate, nor is it limited to whether the first metal layer M3 and the second metal layer M4 are adjacent metal layers.

In an embodiment, referring to FIGS. 4 and 7, the physical part 10 of the first metal layer M3 includes a first power structure PVDD, and the first power structure PVDD is configured to provide a first power voltage VPVDD. Referring to FIGS. 5 and 7, the physical part 20 of the second metal layer M4 includes a second power structure PVEE, and the second power structure PVEE is configured to provide a second power voltage VPVEE. In this way, in a direction perpendicular to the plane where the substrate is located, at least one of the first power structure PVDD and the second power structure PVEE may be configured to cover the first shielding area CC, that is, to cover the first active portion q1 of the pixel circuit 110.

It may be understood that the display panel includes a plurality of light emitting diodes 200. As shown in FIGS. 4 and 7, the first power structure PVDD (configured to provide the first power voltage VPVDD) is electrically connected to the pixel circuit 110, and the pixel circuit 110 is electrically connected to the first electrode 201 of a light emitting diode 200. As shown in FIGS. 5 and 7, the second power structure PVEE (configured to provide the second power voltage VPVEE) is electrically connected to the second electrode 202 of the light emitting diode 200.

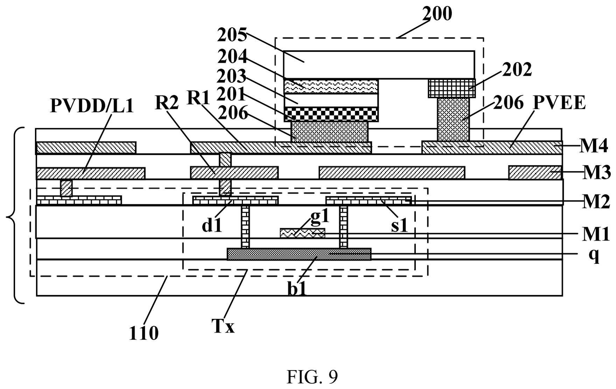

Exemplarily, FIG. 9 is a schematic diagram of a partial cross-sectional view of a display panel, in accordance with an embodiment of the present disclosure. As shown in FIG. 9, a light emitting diode 200 includes a first semiconductor layer 203, a quantum well layer 204, and a second semiconductor layer 205 which are stacked. The first semiconductor layer 203 is electrically connected to the first electrode 201, and the second semiconductor layer 205 is electrically connected to the second electrode 202. The first power structure PVDD located in the first metal layer M3 is electrically connected to the pixel circuit 110, and the pixel circuit 110 is further electrically connected to the first electrode 201 of the light emitting diode 200, and the second power structure PVEE located in the metal layer M4 is electrically connected to the second electrode 202 of the light emitting diode 200.

It should be noted that in the present disclosure, the electrical connection between two components may be direct electrical connection or indirect electrical connection. For example, as shown in FIG. 9, the second power structure PVEE located in the metal layer M4 is electrically connected to the second electrode 202 of the light emitting diode 200 through the bonding layer 206, and the pixel circuit 110 is electrically connected to the first electrode 201 of the light emitting diode 200 through an auxiliary electrode located in the metal layer M3, an auxiliary electrode located in the metal layer M4, and the bonding layer.

It should also be noted that FIG. 9 is an example in which the first electrode 201 and the second electrode 202 of the light emitting diode 200 are both facing the array substrate 100, and the light emitting diode 200 is a flip-chip structure. Alternatively, the first electrode 201 and the second electrode 202 of the light emitting diode 200 may also be both away from the array substrate 100, and the light emitting diode 200 is a formal structure. The first electrode 201 and the second electrode 202 of the light emitting diode 200 may also have one facing the array substrate 100 and the other away from the array substrate 100, and the light emitting diode 200 is a vertical structure. When the light emitting diode 200 is a formal structure or a vertical structure, it does not affect the electrical connection relationship of the light emitting diode 200. That is, the first power structure PVDD located in the first metal layer M3 is still electrically connected to the pixel circuit 110, and the pixel circuit 110 is electrically connected to the first electrode 201 of the light emitting diode 200, and the second power structure PVEE located in the metal layer M4 is electrically connected to the second electrode 202 of the light emitting diode 200.

In existing light emitting diode display panels, the first power structure PVDD usually adopts a grid line distribution, and due to process limitations, the thickness of the metal layer where the first power structure PVDD is located is limited to a certain extent, resulting in a large impedance of the first power structure PVDD. The IR drop of the entire surface of the first power structure PVDD varies greatly, which easily affects the brightness uniformity of the display panel.

Similarly, in existing light emitting diode display panels, the second power structure PVEE also usually adopts a grid line distribution, and due to process limitations, the thickness of the metal layer where the second power structure PVDD is located is also limited to a certain extent, resulting in a larger impedance of the second power structure PVEE. The IR drop of the entire surface of the second power structure PVEE varies greatly, which easily affects the brightness uniformity of the display panel.

In the display panel provided by the embodiments of the present disclosure, in a direction perpendicular to the plane where the substrate is located, if at least one of the first power structure PVDD and the second power structure PVEE is configured to cover the first shielding area CC, it is necessary to increase the area of the first power structure PVDD and/or the area of the second power structure PVEE to ensure that at least one of the first power structure PVDD and the second power structure PVEE covers the first shielding area CC. When the area of the first power structure PVDD is increased, the impedance of the first power structure PVDD may be reduced, thereby improving the display brightness uniformity of the display panel. When the area of the second power structure PVEE is increased, the impedance of the second power structure PVEE may be reduced, thereby improving the display brightness uniformity of the display panel. When the area of the first power structure PVDD and the area of the second power structure PVEE are increased at the same time, the impedance of the first power structure PVDD may be reduced, and the impedance of the second power structure PVEE may also be reduced, thereby improving the display brightness uniformity of the display panel.

As shown in FIG. 7, in the display panel, the pixel circuit 110 and the light emitting diode 200 are arranged in a one-to-one correspondence. In the partial layout structure of the display panel shown in FIGS. 2 and 5, a schematic diagram of the bonding positions of the first electrode 201 and the second electrode 202 of the light emitting diode 200 is also shown. For the convenience of marking, the bonding positions of the first electrode 201 and the second electrode 202 of the light emitting diode 200 are used to represent the light emitting diode 200. As shown in FIGS. 2 and 5, in the display panel, at least two light emitting diodes 200 form a light emitting element group 210. Correspondingly, as shown in FIGS. 2 and 3, at least two pixel circuits 110 form a pixel circuit group 120. The first active portion q1 of each pixel circuit 110 in the pixel circuit group 120 is located in the first shielding area CC.

In an embodiment, as shown in FIGS. 2 and 5, light emitting diodes 200 include a first light emitting diode 211, a second light emitting diode 212 and a third light emitting diode 213. The first light emitting diode 211 may be configured to emit red light, the second light emitting diode 212 may be configured to emit green light, and the third light emitting diode 213 may be configured to emit blue light. A light emitting element group 210 includes a first light emitting diode 211, a second light emitting diode 212 and a third light emitting diode 213. Correspondingly, as shown in FIGS. 2 and 3, a pixel circuit group 120 includes a pixel circuit 110 that drives the first light emitting diode 211 to emit light, a pixel circuit 110 that drives the second light emitting diode 212 to emit light, and a pixel circuit 110 that drives the third light emitting diode 213 to emit light.

On this basis, in an embodiment, as shown in FIGS. 2 and 4, in a direction perpendicular to the plane where the substrate is located, the first power structure PVDD at least partially overlaps with a pixel circuit group 120, and the second power structure PVEE at least partially overlaps with a pixel circuit group 120. Further, in an embodiment, as shown in FIGS. 2 and 4, the orthographic projection area of the first power structure PVDD on the plane where the substrate is located covers the orthographic projection area of a pixel circuit group 120 on the plane where the substrate is located, and the orthographic projection area of the second power structure PVEE on the plane where the substrate is located covers the orthographic projection area of a pixel circuit group 120 on the plane where the substrate is located.

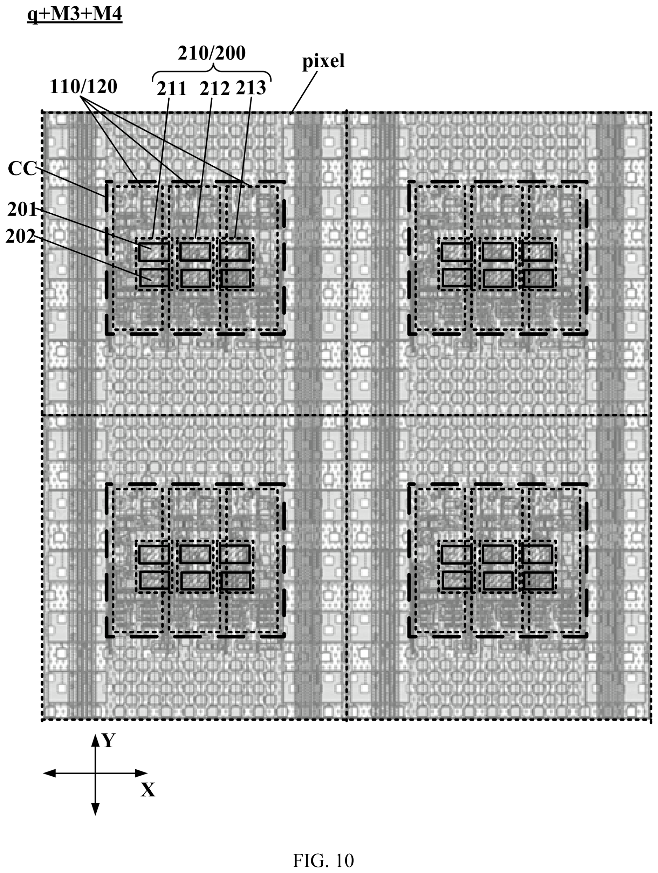

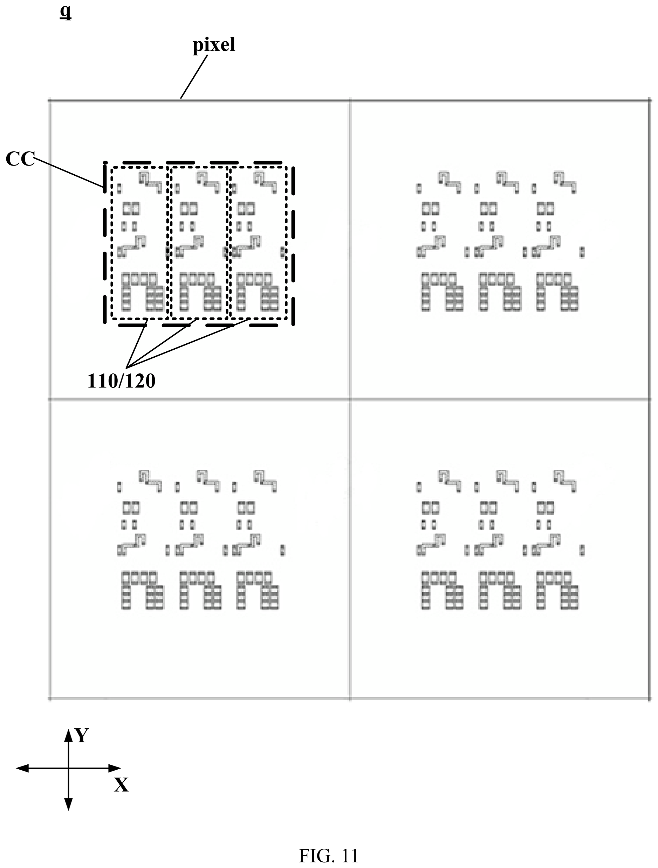

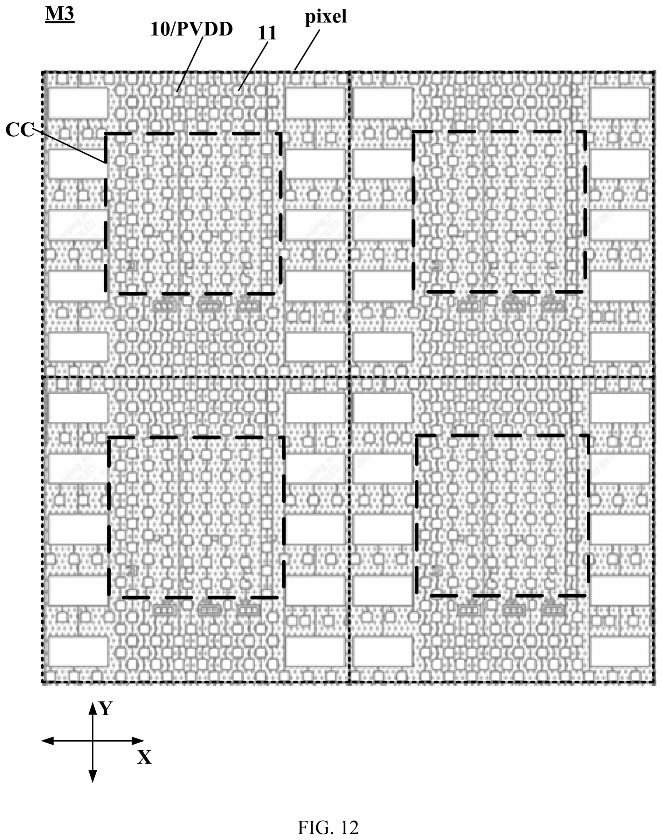

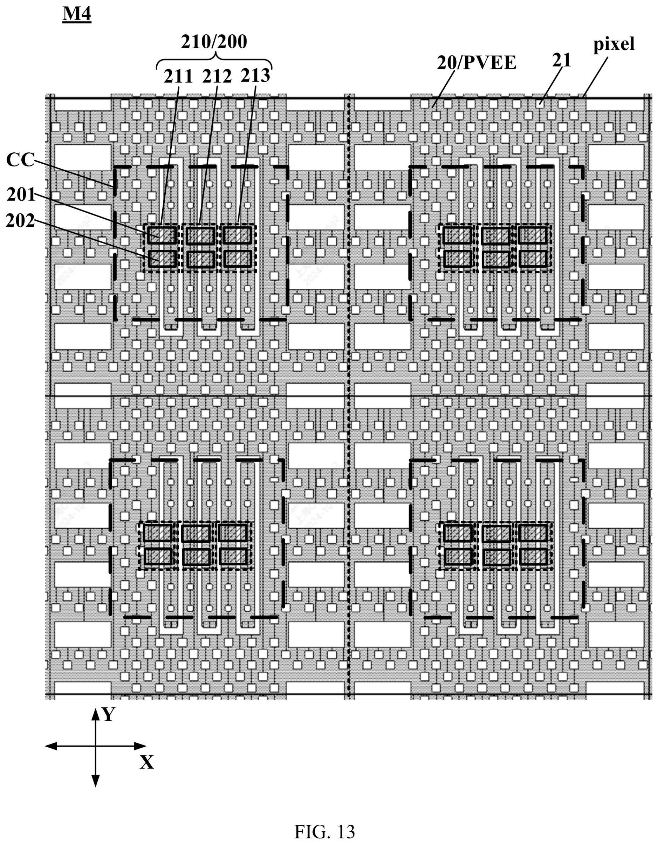

Alternatively, FIG. 10 shows a schematic diagram of a partial layout structure of another display panel, in accordance with an embodiment of the present disclosure. Similar to FIG. 2, for clarity purposes, FIG. 10 only shows the layout structure of the active layer q, the layout structure of the first metal layer M3, the layout structure of the second metal layer M4, and the bonding positions of the first electrode 201 and the second electrode 202 of the light emitting diode 200. FIG. 11 shows a schematic diagram of the layout structure of the active layer q in FIG. 10, FIG. 12 shows a schematic diagram of the layout structure of the first metal layer M3 in FIG. 10, and FIG. 13 shows a schematic diagram of the layout structure of the second metal layer M4 in FIG. 10. As shown in FIGS. 10 and 13, a light emitting element group 210 is arranged in rows along the first direction X, and multiple rows of light emitting element groups 210 are arranged along the second direction Y, where the first direction X and the second direction Y intersect, and the first direction X and the second direction Y are parallel to the plane where the substrate is located. In an embodiment, the first direction X and the second direction Y are perpendicular. That is, the light emitting element groups 210 are arranged in an array along the first direction X and the second direction Y. Correspondingly, as shown in FIGS. 10 and 11, a pixel circuit group 120 is arranged in rows along the first direction X, and multiple rows of pixel circuit groups 120 are arranged along the second direction Y. That is, the pixel circuit groups 120 may also be arranged in an array in the first direction X and the second direction Y.

As shown in FIGS. 10-13, in a direction perpendicular to the plane where the substrate is located, the first power supply structure PVDD at least partially overlaps with the four pixel circuit groups 120 that include two adjacent rows of pixel circuit groups 120 and two adjacent columns of pixel circuit groups 120. In an embodiment, as shown in FIGS. 10-13, the orthographic projection area of the first power structure PVDD on the plane where the substrate is located covers the orthographic projection areas of the 2*2 pixel circuit groups 120 on the plane where the substrate is located.

As shown in FIGS. 10-13, in a direction perpendicular to the plane where the substrate is located, the second power supply structure PVEE at least partially overlaps with the four pixel circuit groups 120 that include two adjacent rows of pixel circuit groups 120 and two adjacent columns of pixel circuit groups 120. In an embodiment, as shown in FIGS. 10-13, the orthographic projection area of the second power supply structure PVEE on the plane where the substrate is located covers the orthographic projection areas of 2*2 pixel circuit groups 120 on the plane where the substrate is located.

By analogy, the orthographic projection area of the first power structure PVDD on the plane where the substrate is located may also cover 3*3, 3*4, 4*3, 4*4, ..., of pixel circuit groups 120 in different matrices and the orthographic projection areas of all pixel circuit groups 120 on the plane where the substrate is located. The orthographic projection area of the first power structure PVDD on the plane where the substrate is located may even cover the entire display area of the display panel. As the orthographic projection area of the first power structure PVDD on the plane where the substrate is located increases, the area of the first power structure PVDD increases, and the impedance of the first power structure PVDD decreases, which is more conducive to improving the display brightness uniformity of the display panel.

Similarly, the orthographic projection area of the second power structure PVEE on the plane where the substrate is located may also cover 3*3, 3*4, 4*3, 4*4, ..., of pixel circuit groups 120 in different matrices and the orthographic projection areas of all pixel circuit groups 120 on the plane where the substrate is located. The orthographic projection area of the second power structure PVEE on the plane where the substrate is located may even cover the entire display area of the display panel. As the orthographic projection area of the second power structure PVEE on the plane where the substrate is located increases, the area of the second power structure PVEE increases, and the impedance of the second power structure PVEE decreases, which is more conducive to improving the display brightness uniformity of the display panel.

It should be noted that a pixel circuit group 120 and a light emitting element group 210 form a pixel unit (shown as "pixel" in the drawings). FIGS. 2-5 schematically illustrate a pixel unit, and FIG. 10-13 schematically illustrate four pixel units, and these four pixel units form a matrix of two rows and two columns (i.e., 2*2) along the first direction X and the second direction Y. In order to clearly distinguish different pixel units, in FIGS. 10-13, horizontal lines and vertical lines are used to indicate the boundaries of adjacent pixel unit areas along the first direction X and the second direction Y. It may be understood that this boundary is only for the convenience of explanation and is not intended to limit the present disclosure.

As shown in FIG. 7, the pixel circuit 110 includes a pulse width module 111 and an amplitude module 112. From the above analysis of the pixel circuit 110, it can be seen that although the pulse width module 111 in the pixel circuit 110 is also connected to the turn-off voltage Voff, and the turn-off voltage Voff is similar to the first power supply voltage VPVDD. However, since the amplitude module 112 directly drives the light emitting diode 200, the first power supply structure PVDD is thus electrically connected to the amplitude module 112 of the pixel circuit 110, that is, the first power supply structure PVDD provides the first power supply voltage VPVDD to the amplitude module 112 of the pixel circuit 110. In this way, by increasing the area of the first power supply structure PVDD, the brightness uniformity of the display panel may be more directly improved.

The first shielding area CC may be covered in a direction perpendicular to the plane of the substrate by increasing the area of the first power structure PVDD and the area of the second power structure PVEE, and the impedance of the first power structure PVDD and the impedance of the second power structure PVEE may be reduced, thereby improving the brightness uniformity of the display panel. However, firstly, in the actual process, arc discharge is prone to occur when a large area of metal is introduced into a vacuum machine for patterning, so that the area of the first power structure PVDD and the area of the second power structure PVEE are subject to certain restrictions. Secondly, after the area of the first power structure PVDD and the area of the second power structure PVEE are increased, if the overlapping area of the first power structure PVDD and the second power structure PVEE is large, the short circuit of the two metal layers may be easily caused when the insulating layer between the first metal layer M3 and the second metal layer M4 is damaged. Thirdly, when the insulating layer between the first metal layer M3 and the second metal layer M4 is an organic material layer, openings are also required in the first metal layer M3 and the second metal layer M4 to meet the gas release requirements.

In summary, it is necessary to open a plurality of openings 11 in the first metal layer M3 to reduce the area of the first power structure PVDD, and to open a plurality of openings 21 in the second metal layer M4 to reduce the area of the second power structure PVEE, thereby reducing the risk of arc discharge when the first metal layer M3 and the second metal layer M4 enter the vacuum machine for patterning. It is also possible to reduce the overlapping area of the first power structure PVDD and the second power structure PVEE in a direction perpendicular to the plane where the substrate is located, thereby reducing the risk of short circuit between the first power structure PVDD and the second power structure PVEE when the insulating layer between the first metal layer M3 and the second metal layer M4 is damaged. Further, forming a plurality of openings 11 in the first metal layer M3 and a plurality of openings 21 in the second metal layer M4 is conducive to the gas release of the organic insulating layer between the first metal layer M3 and the second metal layer M4.

The opening design of the first metal layer M3 and the second metal layer M4 is further described in detail below.

In an embodiment, as shown in FIG. 4, the openings 11 of the first metal layer M3 include a plurality of first openings K1. As shown in FIG. 5, the openings 21 of the second metal layer M4 include a plurality of second openings K2. Referring to FIGS. 4, 5 and 14, FIG. 14 is a schematic diagram of a stacking diagram in which the layout structure of the first metal layer M3 in FIG. 4 and the layout structure of the second metal layer M4 in FIG. 5 are stacked together. In the first shielding area CC, in a direction perpendicular to the plane where the substrate is located, the first openings K1 and the second openings K2 do not overlap. That is, the first openings K1 and the second openings K2 are arranged in an alternating and complementary manner. The first openings K1 of the first metal layer M3 are blocked by the physical part 20 of the second metal layer M4, and the second openings K2 of the second metal layer M4 are blocked by the physical part 10 of the first metal layer M3, thereby avoiding affecting the active layer q in the first shielding area CC when laser bonding a light emitting diode, and further avoiding affecting the performance of a thin film transistor including the active layer q in the first shielding area CC.

In an embodiment, as shown in FIG. 4, in at least a partial area CC1 of the first shielding area CC, the first openings K1 are arranged in columns along the second direction Y, a plurality of columns of first openings K1 are arranged along the first direction X. The first openings K1 in alternate columns overlap along the first direction X, and the first openings K1 in adjacent columns at least partially do not overlap along the first direction X. Further, in an embodiment, as shown in FIG. 4, in at least a partial area CC1 of the first shielding area CC, the first openings K1 in alternate columns are arranged the same along the first direction X, and the first openings K1 in adjacent columns are alternatingly arranged along the first direction X.

Additionally, or alternatively, as shown in FIG. 5, in at least a partial area CC1 of the first shielding area CC, the second openings K2 are arranged in columns along the second direction Y, and a plurality of columns of second openings K2 are arranged along the first direction X. The second openings K2 of alternate columns overlap along the first direction X, and the second openings K2 of adjacent columns at least partially do not overlap along the first direction X. Further, in an embodiment, as shown in FIG. 5, in at least a partial area CC1 of the first shielding area CC, the second openings K2 of alternate columns are arranged the same along the first direction X, and the second openings K2 of adjacent columns are alternatingly arranged along the first direction X.

It may be understood that, in the first shielding area CC, in a direction perpendicular to the plane where the substrate is located, the first openings K1 and the second openings K2 do not overlap, and in at least a partial area CC1 of the first shielding area CC, the first openings K1 of the alternate columns are arranged in the same manner along the first direction X, and the first openings K1 of adjacent columns are alternatingly arranged along the first direction X. At the same time, the second openings K2 of the alternate columns are arranged in the same manner along the first direction X, and the second openings K2 of adjacent columns are alternatingly arranged along the first direction X. Accordingly, referring to FIGS. 4, 5, 14 and 15, FIG. 15 shows a schematic diagram of a partially enlarged view of the area CC1 in the first shielding area CC. It can be seen that the orthographic projections of the first openings K1 and the second openings K2 on the first metal layer M3 are alternating and complementary. Similarly, the orthographic projections of the first openings K1 and the second openings K2 on the second metal layer M4 are arranged in an alternating and complementary manner. The first openings K1 of the metal layer M3 are blocked by the physical part 20 of the second metal layer M4, and the second openings K2 of the second metal layer M4 are blocked by the physical part 10 of the first metal layer M3. In this way, not only the physical part 10 of the first metal layer M3 and the physical part 20 of the second metal layer M4 jointly block the first shielding area CC, but also the overlapping area between the physical part 10 of the first metal layer M3 and the physical part 20 of the second metal layer M4 in the direction perpendicular to the plane of the substrate is minimal, thereby reducing the risk of short circuit between the first metal layer M3 and the second metal layer M4 when the insulating layer between the first metal layer M3 and the second metal layer M4 is damaged.

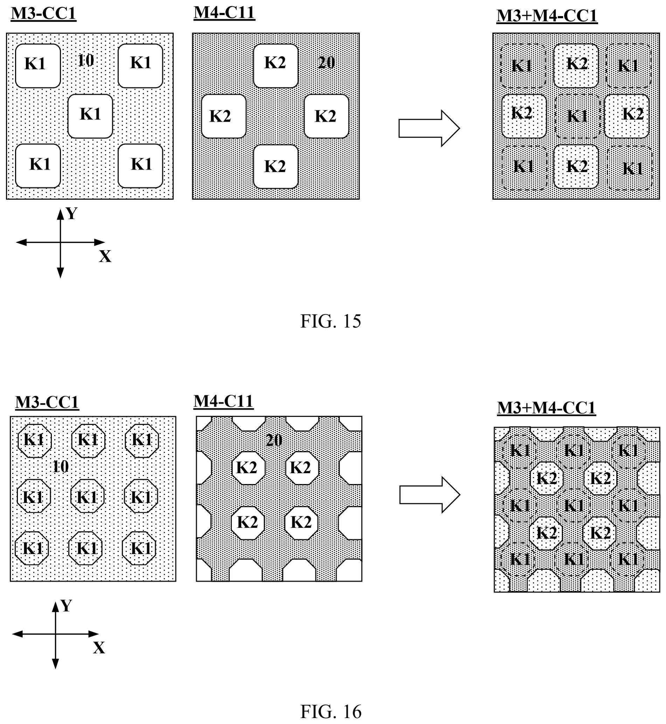

Alternatively, as shown in FIG. 16, in at least a partial area CC1 in the first shielding area CC, the first openings K1 are arranged in columns along the second direction Y, a plurality of columns of first openings K1 are arranged along the first direction X, the first openings K1 in adjacent columns overlap along the first direction X, and the first openings K1 in alternate columns overlap along the first direction X. Further, in an embodiment, as shown in FIG. 15, in at least a partial area CC1 in the first shielding area CC, the first openings K1 in adjacent columns are arranged the same along the first direction X, and the first openings K1 in alternate columns are arranged the same along the first direction X.

Additionally or alternatively, as shown in FIG. 16, in at least a partial area CC1 of the first shielding area CC, the second openings K2 are arranged in columns along the second direction Y, a plurality of columns of second openings K2 are arranged along the first direction X, the second openings K2 in adjacent columns overlap along the first direction X, and the second openings K2 in alternate columns overlap along the first direction X. Further, in an embodiment, as shown in FIG. 16, in at least a partial area CC1 of the first shielding area CC, the second openings K2 in adjacent columns are arranged the same along the first direction X, and the second openings K2 in alternate columns are arranged the same along the first direction X.

It may be understood that, in the first shielding area CC, in a direction perpendicular to the plane where the substrate is located, the first openings K1 and the second openings K2 do not overlap, and in at least a partial area CC1 of the first shielding area CC, the first openings K1 of adjacent columns are arranged in the same manner along the first direction X, and the first openings K1 of the alternate columns are arranged in the same manner along the first direction X. At the same time, the second openings K2 of adjacent columns are arranged in the same manner along the first direction X, and the second openings K2 of the alternate columns are arranged in the same manner along the first direction X. Accordingly as shown in FIG. 16, the orthographic projections of the first openings K1 and the second openings K2 on the first metal layer M3 are arranged in an alternating and complementary manner. Similarly, the orthographic projections of the first openings K1 and the second openings K2 on the second metal layer M4 are arranged in an alternating and complementary manner. The first openings K1 of the first metal layer M3 are physically blocked by the physical part 20 of the second metal layer M4. The second openings K2 of the second metal layer M4 are blocked by the physical part 10 of the first metal layer M3. In this way, not only the physical part 10 of the first metal layer M3 and the physical part 20 of the second metal layer M4 jointly block the first shielding area CC, but also the overlapping area of the physical part 10 of the first metal layer M3 and the physical part 20 of the second metal layer M4 in a direction perpendicular to the plane where the substrate is located is minimal, thereby reducing the risk of short circuit between the first metal layer M3 and the second metal layer M4 when the insulating layer between the first metal layer M3 and the second metal layer M4 is damaged.

In an embodiment, as shown in FIGS. 15 and 16, the shape of the first openings K1 and the shape of the second openings K2 may be the same, so as to facilitate the layout design of the first metal layer M3 and the second metal layer M4, but the present disclosure is not limited thereto. Alternatively, the shape of the first openings K1 may be different from the shape of the second openings K2, depending on the specific situation.

In an embodiment, as shown in FIGS. 15 and 16, the shape of the first openings K1 and the shape of the second openings K2 may be a polygon. For example, as shown in FIG. 15, the shape of the first openings K1 and the shape of the second openings K2 are arc-angled rectangles. For another example, as shown in FIG. 16, the shape of the first openings K1 and the shape of the second openings K2 are octagons. By comparing FIGS. 15 and 16, it can be seen that compared with the shape of the first openings K1 and the shape of the second openings K2 being octagons, when the shape of the first openings K1 and the shape of the second openings K2 are square, the overlapping area of the physical part 10 of the first metal layer M3 and the physical part 20 of the second metal layer M4 in a direction perpendicular to the plane where the substrate is located is relatively smaller, which may further reduce the risk of short circuit between the first metal layer M3 and the second metal layer M4 when the insulating layer between the first metal layer M3 and the second metal layer M4 is damaged.

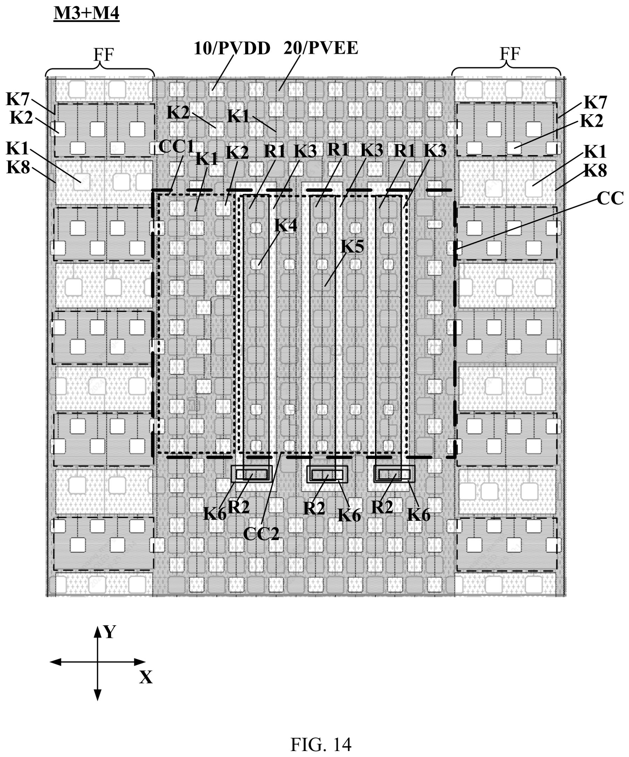

In an embodiment, as shown in FIGS. 5 and 14, the physical part 20 of the second metal layer M4 further includes a first auxiliary electrode R1, and a third opening K3 is provided between the first auxiliary electrode R1 and the second power structure PVDD, so that the first auxiliary electrode R1 and the second power structure PVDD are insulated from each other. Since the physical part 10 of the first metal layer M3 and the physical part 20 of the second metal layer M4 jointly cover the first shielding area CC in a direction perpendicular to the plane where the substrate is located, at least the portion of the third opening K3 located in the first shielding area CC is shielded by the physical part 10 of the first metal layer M3.

Referring to FIGS. 3, 5 and 9, the first auxiliary electrode R1 is electrically connected to the pixel circuit 110, and the first auxiliary electrode R1 is electrically connected to the first electrode 201 of the light emitting diode 200. That is, the pixel circuit 110 is electrically connected to the first electrode 201 of the light emitting diode 200 through the first auxiliary electrode R1. It may be understood that one pixel circuit 110 needs to be provided with one first auxiliary electrode R1, so as to be electrically connected to the first electrode 201 of the corresponding light emitting diode 200 through the first auxiliary electrode R1.

As can be seen from the above, at least two pixel circuits 110 form a pixel circuit group 120, and one pixel circuit group 120 corresponds to one pixel unit. In an embodiment, as shown in FIGS. 2 and 3, three pixel circuits 110 form one pixel circuit group 120, so that in one pixel unit, one first auxiliary electrode R1 needs to be respectively provided for each of the three pixel circuits 110 to be electrically connected to the first electrode 201 of the light emitting diode 200 corresponding to each of them. In an embodiment, as shown in FIGS. 5 and 14, a plurality of fourth openings K4 are provided in a first auxiliary electrode R1 and in the second power structure PVEE between two adjacent first auxiliary electrodes R1. Since the area of the first auxiliary electrode R1 and the area of the second power structure PVEE between two adjacent first auxiliary electrodes R1 are small, the area of a fourth opening K4 provided in the first auxiliary electrode R1 and the second power structure PVEE between two adjacent first auxiliary electrodes R1 also needs to be small. In an embodiment, the area of a fourth opening K4 is smaller than the area of a second opening K2.

It should be noted that the area of a first opening K1 in the first metal layer M3 and the area of a second opening K2 in the second metal layer M4 may be relatively large. In this way, on one hand, the area of the physical part 10 of the first metal layer M3 and the area of the physical part 20 of the second metal layer M4 may be reduced, which is convenient for patterning in a vacuum machine. On the other hand, the overlapping area of the physical part 10 of the first metal layer M3 and the physical part 20 of the second metal layer M4 in the direction perpendicular to the plane of the substrate may also be reduced. In addition, it is conducive to sufficient gas release. Apparently, the more openings are formed in the first metal layer M3 and the second metal layer M4 (e.g., a plurality of fourth openings K4 are provided in the first auxiliary electrode R1 and the second power structure PVEE between two adjacent first auxiliary electrodes R1), the more improved effects of these three aspects.

Since the fourth openings K4 different from the second openings K2 are provided in the first auxiliary electrode R1 and the second power structure PVEE between two adjacent first auxiliary electrodes R1, in a direction perpendicular to the plane where the substrate is located, the portion where the first power structure PVDD overlaps with the first auxiliary electrode R1 and the second power structure PVEE between the two adjacent first auxiliary electrodes R1 may also adopt a design different from the first openings K1. In an embodiment, referring to FIGS. 4, 5 and 14, the area where the first auxiliary electrode R1 and the second power structure PVEE between the two adjacent first auxiliary electrodes R1 are located is set as area CC2, then in a direction perpendicular to the plane where the substrate is located, the portion where the first power structure PVDD overlaps with the first auxiliary electrode R1 and the second power structure PVEE between the two adjacent first auxiliary electrodes R1 (i.e., the portion where the first power structure PVDD is located in area CC2) may be provided with a plurality of fifth openings K5, and the arrangement of the fifth openings K5 may be different from the arrangement of the first openings K1.

In an embodiment, as shown in FIG. 4, the fifth openings K5 are arranged in columns along the second direction Y, a plurality of columns of fifth openings K5 are arranged along the first direction X. The fifth openings K5 in adjacent columns overlap along the first direction X, and the fifth openings K5 in alternate columns overlap along the first direction X. Further, in an embodiment, as shown in FIG. 4, in area CC2, the fifth openings K5 in adjacent columns are arranged the same along the first direction X, and the fifth openings K5 in alternate columns are arranged the same along the first direction X.

In an embodiment, referring to FIGS. 4, 5 and 14, the orthographic projections of the fourth openings K4 and the fifth openings K5 on the first metal layer M3 are alternately arranged along the second direction Y. That is, the orthographic projections of the fourth openings K4 and the fifth openings K5 on the first metal layer M3 are arranged in an alternating and complementary manner. The fifth openings K5 of the first metal layer M3 are blocked by the physical part 20 of the second metal layer M4, and the fourth openings K4 of the second metal layer M4 are blocked by the physical part 10 of the first metal layer M3, so that not only the physical part 10 of the first metal layer M3 and the physical part 20 of the second metal layer M4 jointly block the first shielding area CC, but also the overlapping area of the physical part 10 of the first metal layer M3 and the physical part 20 of the second metal layer M4 in a direction perpendicular to the plane where the substrate is located is small, thereby reducing the risk of short circuit between the first metal layer M3 and the second metal layer M4 when the insulating layer between the first metal layer M3 and the second metal layer M4 is damaged.

It is to be noted that, since a partial area of the second metal layer M4 needs to be bonded to the light emitting diode, the area of the second metal layer M4 that needs to be bonded to the light emitting diode cannot be provided with an opening. However, this does not affect the provision of an opening in the first metal layer M3 that overlaps with the area of the second metal layer M4 where the light emitting diode needs to be bonded in a direction perpendicular to the plane where the substrate is located. As shown in FIGS. 4, 5 and 14, in a direction perpendicular to the plane where the substrate is located, a plurality of fifth openings K5 are provided in the first metal layer M3 that overlaps with an area of the second metal layer M4 where the light emitting diode needs to be bonded.

In the first metal layer M3, the fifth openings K5 may the same as the first openings K1 in shape and area, but the arrangement of the fifth openings K5 and the first openings K1 may be different.

As can be seen above, a first auxiliary electrode R1 located in the second metal layer M4 is electrically connected to a pixel circuit 110. In an embodiment, as shown in FIG. 9, the first metal layer M3 and the second metal layer M4 are located on the side of the pixel circuit 110 away from the substrate, and the second metal layer M4 is located on the side of the first metal layer M3 away from the substrate. Referring to FIGS. 4, 5, 9 and 14, the physical part 10 of the first metal layer M3 further includes a second auxiliary electrode R2, and a sixth opening K6 is provided between the second auxiliary electrode R2 and the first power structure PVDD, so that the second auxiliary electrode R2 and the first power structure PVDD are insulated from each other. In a direction perpendicular to the plane where the substrate is located, the first auxiliary electrode R1 at least partially overlaps with the second auxiliary electrode R2, and the first auxiliary electrode R1 and the second auxiliary electrode R2 are electrically connected through a via hole between the first metal layer M3 and the second metal layer M4, and the second auxiliary electrode R2 is electrically connected to the pixel circuit 110.

It may be understood that, in the first metal layer M3, the second auxiliary electrode R2 and the first power structure PVDD are insulated from each other by the sixth opening K6. In the second metal layer M4, the first auxiliary electrode R1 and the second power structure PVEE are insulated from each other by the third opening K3. In a direction perpendicular to the plane where the substrate is located, the first auxiliary electrode R1 at least partially overlaps with the second auxiliary electrode R2, so that the first auxiliary electrode R1 is electrically connected to the second auxiliary electrode R2, so that in a direction perpendicular to the plane where the substrate is located, the third opening K3 and the sixth opening K6 may at least partially overlap. That is, the first metal layer M3 and the second metal layer M4 may be hollowed out in the part where the third opening K3 and the sixth opening K6 overlap. If this part of the hollowed-out area overlaps with the active layer q, then when the light emitting diode is laser bonded, it may affect the active layer q that overlaps with this part of the hollowed-out area.

Based on this, in an embodiment, as shown in FIGS. 4, 5 and 14, the first auxiliary electrode R1 may be extended outside the first shielding area CC to be electrically connected to the second auxiliary electrode R2. That is, the sixth opening K6 formed in the first metal layer M3 is located outside the first shielding area CC, so that in the direction perpendicular to the plane of the substrate, the hollow area where the third opening K3 and the sixth opening K6 overlap will not overlap with the active layer q, so that when laser bonding the light emitting diode, the active layer q will not be affected by the hollow area where the third opening K3 and the sixth opening K6 overlap.

Alternatively, the sixth opening K6 may be located in the first shielding area CC, but in a direction perpendicular to the plane of the substrate, the sixth opening K6 does not overlap with the active layer q. Thus, in a direction perpendicular to the plane of the substrate, the hollow area where the third opening K3 and the sixth opening K6 overlap will not overlap with the active layer q. Therefore, when laser bonding the light emitting diode is performed, the active layer q will not be affected by the hollow area where the third opening K3 and the sixth opening K6 overlap.

As can be seen above, a pixel circuit group 120 is electrically connected to a light emitting element group 210 to form a pixel unit. Since the pixel circuit 110 is located in the array substrate 100, as shown in FIG. 9, the pixel circuit 110 is usually composed of an active layer q, a metal layer M1 and a metal layer M2, and the light emitting diode 200 is located on the array substrate 100. Accordingly, in a direction perpendicular to the plane where the substrate is located, a pixel circuit group 120 and the electrically connected light emitting element group 210 may at least partially overlap, or may at least partially not overlap. Regardless of whether the pixel circuit group 120 and the electrically connected light emitting element group 210 overlap, a sixth opening K6 is set outside the first shielding area CC. Alternatively, even if the sixth opening K6 is located in the first shielding area CC, but in a direction perpendicular to the plane where the substrate is located, the sixth opening K6 is set not to overlap with the active layer q, which may avoid the active layer q being affected by the hollow area where the third opening K3 and the sixth opening K6 overlap.

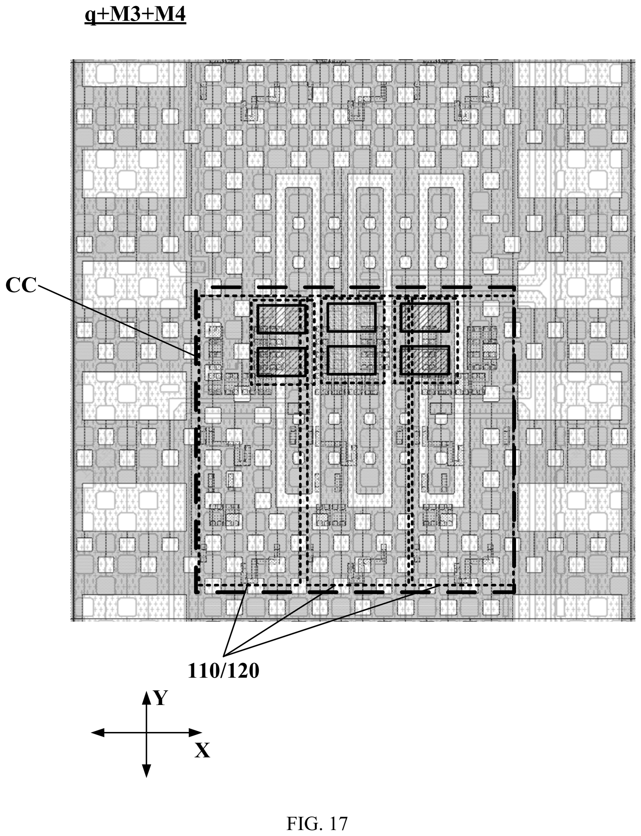

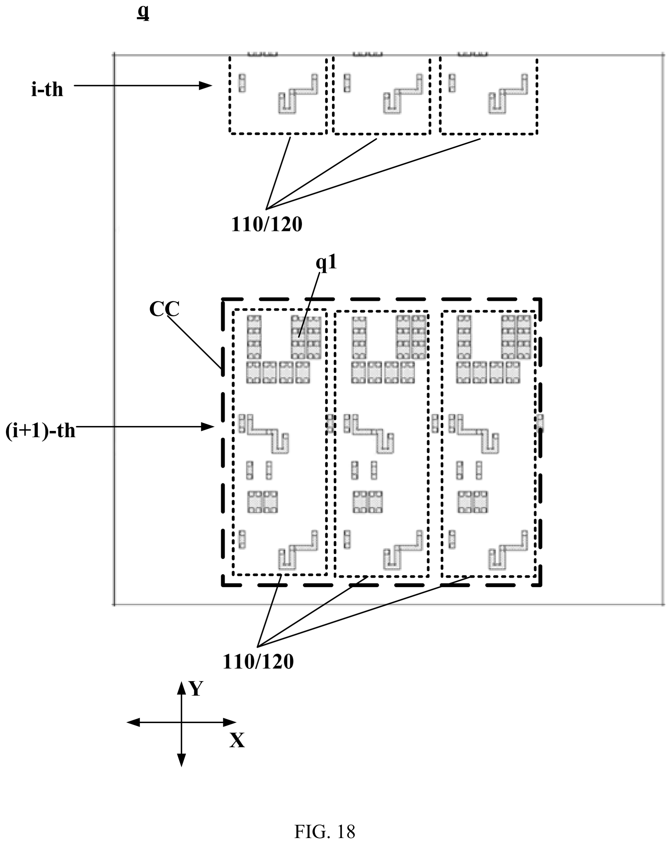

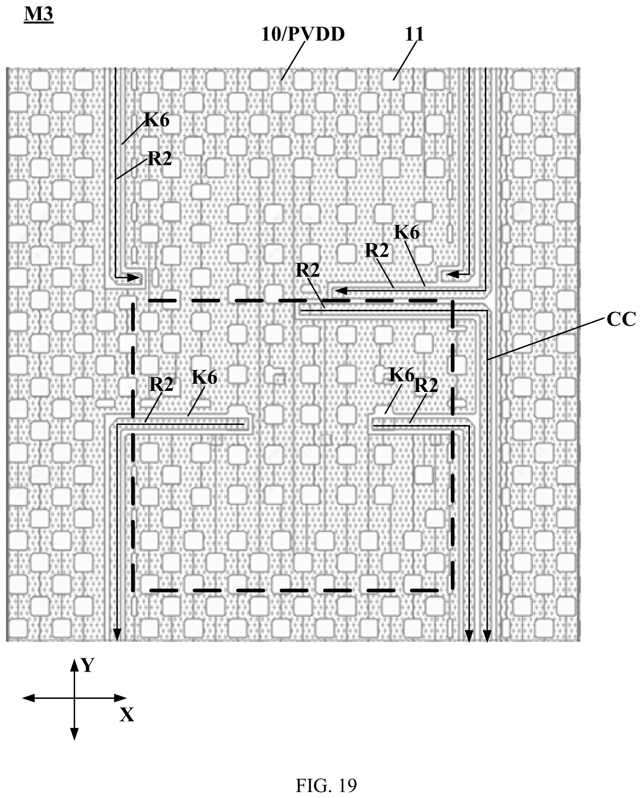

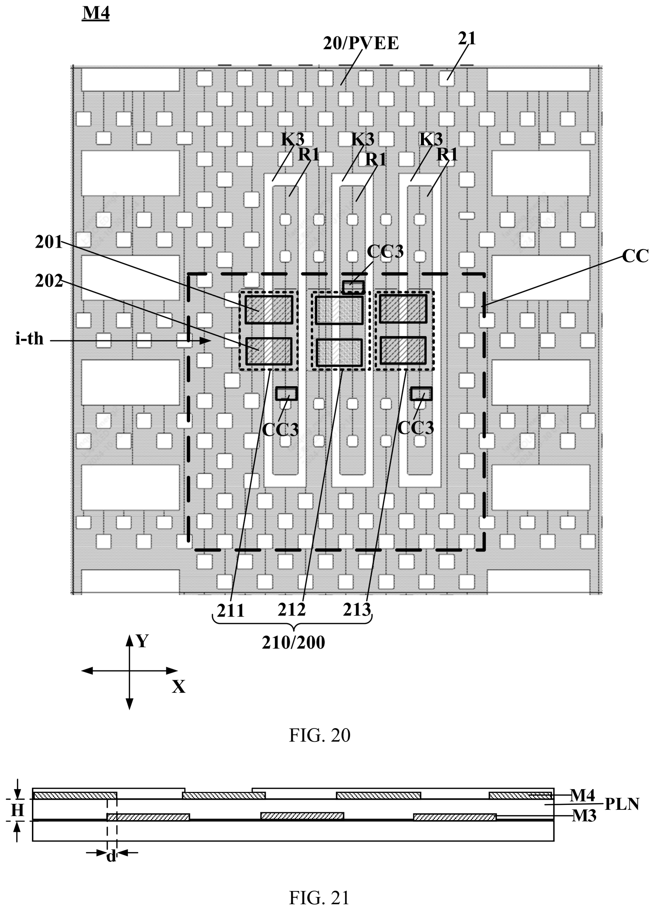

It may be understood that sometimes a pixel circuit group 120 and the electrically connected light emitting element group 210 at least partially do not overlap in the direction perpendicular to the plane of the substrate. In an embodiment, as shown in FIGS. 17-20, FIG. 17 shows a schematic diagram of a partial layout structure of the active layer q, the first metal layer M3 and the second metal layer M4 in another display panel, in accordance with an embodiment of the present disclosure. For clarity, FIG. 18 shows a schematic diagram of the layout structure of the active layer q in FIG. 17, FIG. 19 shows a schematic diagram of the layout structure of the first metal layer M3 in FIG. 17, and FIG. 20 shows a schematic diagram of the layout structure of the second metal layer M4 in FIG. 17. It can be seen that in the direction perpendicular to the plane of the substrate, a pixel circuit group 120 and the electrically connected light emitting element group 210 do not overlap. In other words, a column of pixel circuit groups includes n pixel circuit groups 120, and a column of light emitting element groups includes n light emitting element groups 210. For the corresponding electrically connected column of pixel circuit groups 120 and column of light emitting element groups 210, in a direction perpendicular to the plane of the substrate, the i-th pixel circuit group 120 is electrically connected to the i-th light emitting element group 210, and the (i+1)-th pixel circuit group 120 at least partially overlaps with the light emitting element group 210 (i.e., the i-th light emitting element group 210) electrically connected to the i-th pixel circuit group 120.

As shown in FIGS. 17 to 20, in a direction perpendicular to the plane where the substrate is located, the first auxiliary electrode R1 and the second auxiliary electrode R2 overlap in a partial area CC3 in the first shielding area CC, and the second auxiliary electrode R2 and the sixth opening K6 extend at least partially from the first shielding area CC to outside the first shielding area CC. That is, the second auxiliary electrode R2 needs to be wound, so that in a corresponding electrically connected column of pixel circuit groups 120 and column of light emitting element groups 210, the i-th light emitting element group 210 is electrically connected, in sequence through the first auxiliary electrode R1 and the second auxiliary electrode R2, to the pixel circuit group 120 (i.e., the (i+1)-th pixel circuit group 120) that overlaps the (i+1)-th light emitting element group 210 in a direction perpendicular to the plane where the substrate is located. In FIG. 19, the arrow of the straight line extending along the second auxiliary electrode R2 represents the direction of connection from the light emitting element to the pixel circuit.

At this point, it may be understood that since a sixth opening K6 at least partially extends from the first shielding area CC to outside the first shielding area CC, the sixth opening K6 does not overlap with the active layer q in a direction perpendicular to the plane of the substrate, so as to avoid affecting the active layer q when laser bonding the light emitting diode.

It should be noted that, by being arranged in a direction perpendicular to the plane of the substrate, the pixel circuit group 120 and the electrically connected light emitting element group 210 at least partially do not overlap, thereby compressing the area occupied by the pixel circuit group 120 in the display area of the display panel, so that the driving circuit VSR (including a multi-stage cascaded shift register circuit) that drives the pixel circuit 110 to work may also be placed in the display area of the display panel, which is conducive to realizing a borderless, full-screen design of the display panel and may be applied to spliced display devices.

As shown in FIGS. 7 and 9, the first power structure PVDD is electrically connected to the pixel circuit 110. Specifically, the first power structure PVDD includes a first connection portion L1, and the first connection portion L1 is electrically connected to the pixel circuit 110. It may be understood that, with reference to FIG. 4, since a plurality of openings 11 are provided in the first metal layer M3, the first connection portion L1 may overlap with an opening 11 in a direction perpendicular to the plane where the substrate is located. At this moment, the first connection portion L1 needs to protrude toward the opening 11 in the first metal layer M3, that is, at least part of the first connection portion L1 protrudes toward the opening 11 in the first metal layer M3. In this way, the opening 11 in the first metal layer M3 adjacent to the first connection portion L1 is different in shape from other openings in the first metal layer M3. For example, the area of the opening 11 in the first metal layer M3 adjacent to the first connection portion L1 is smaller than the area of other openings in the first metal layer M3.

As can be seen above, in the first shielding area CC, in a direction perpendicular to the plane where the substrate is located, the openings 11 in the first metal layer M3 and the openings 21 in the second metal layer M4 are arranged in an alternating and complementary manner. The openings 11 in the first metal layer M3 are shielded by the physical part 20 of the second metal layer M4, and the openings 21 in the second metal layer M4 are shielded by the physical part 10 of the first metal layer M3, so that the physical part 10 of the first metal layer M3 and the physical part 20 of the second metal layer M4 jointly cover the first shielding area CC. It may be understood that, as shown in FIG. 21, considering the process error, in the first shielding area CC, the orthographic projection of an opening 21 of the second metal layer M4 on the first metal layer M3 and an opening 11 of the first metal layer M3 need to have a minimum distance d. That is, the edge of the physical part 10 of the first metal layer M3 and the edge of the physical part 20 of the second metal layer M4 overlap. Applicant has found that the minimum distance d between the orthographic projection of an opening 21 of the second metal layer M4 in the first metal layer M3 and the corresponding opening 11 of the first metal layer M3 needs to satisfy:

$$d \geq \frac{X1 + X2}{2} + \sqrt{Y^2 + H^2}$$

(1)

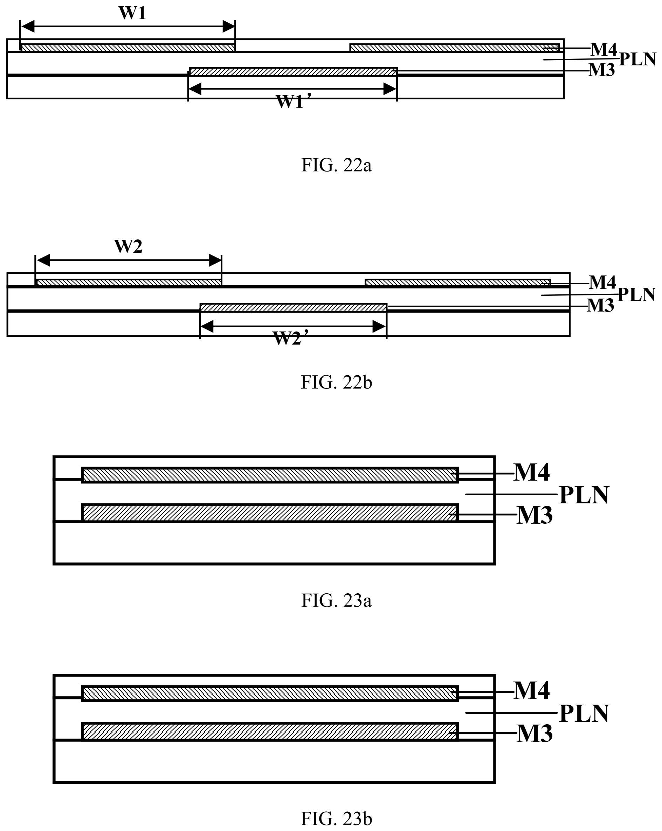

As shown in FIG. 21, H is the thickness of the insulating layer PLN between the first metal layer M3 and the second metal layer M4, X1 is the line width difference between the design pattern of the first metal layer M3 and the actual pattern, and X2 is the line width difference between the design pattern of the second metal layer M4 and the actual pattern. For ease of understanding, FIG. 22a shows a schematic diagram of the cross-sectional structure of a design pattern of the first metal layer M3 and the second metal layer M4, and FIG. 22b shows a schematic diagram of the cross-sectional structure of an actual pattern of the first metal layer M3 and the second metal layer M4. The line width of the design pattern of the first metal layer M3 is W1, and the line width of the actual pattern of the first metal layer M3 is W1'. Then the line width difference X1 between the design pattern of the first metal layer M3 and the actual pattern is W1-W1'. Similarly, the line width of the design pattern of the second metal layer M4 is W2, and the line width of the actual pattern of the second metal layer M4 is W2'. Then the line width difference X2 between the design pattern of the second metal layer M4 and the actual pattern is W2 -W2'.

Y is the fitting accuracy between the first metal layer M3 and the second metal layer M4. FIG. 23a shows a schematic diagram of the cross-sectional structure of another design pattern of the first metal layer M3 and the second metal layer M4. FIG. 23b shows a schematic diagram of the cross-sectional structure of another actual production pattern of the first metal layer M3 and the second metal layer M4. By comparing FIG. 23a and FIG. 23b, it can be seen that due to process errors, the actual production patterns of the first metal layer M3 and the second metal layer M4 will deviate from the design patterns, so that the first metal layer M3 and the second metal layer M4 have a fitting accuracy Y.

It should be noted that, the setting of the minimum distance d between the orthographic projection of the opening 21 of the second metal layer M4 on the first metal layer M3 and the opening 11 of the first metal layer M3 mainly considers the line width difference between the design patterns and the actual production patterns of the first metal layer M3 and the second metal layer M4 in the process, the fitting accuracy between the first metal layer M3 and the second metal layer M4, and the thickness of the insulating layer PLN between the first metal layer M3 and the second metal layer M4. These three factors affect the formation of the openings 11 in the first metal layer M3 and the openings 21 in the second metal layer M4 arranged in an alternating and complementary manner to shield the active layer q.

The above embodiments mainly illustrate how to design the openings 11 of the first metal layer M3 and the openings 21 of the second metal layer M4 in the first shielding area CC.

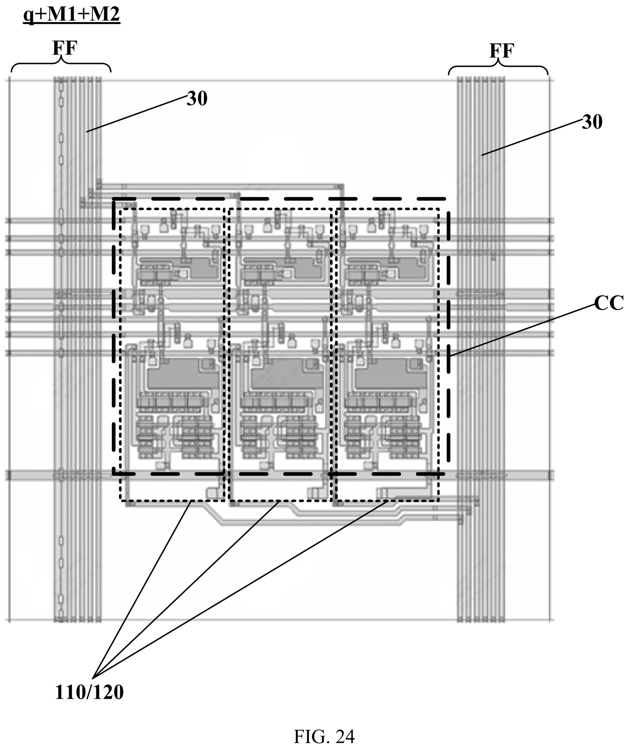

As shown in FIGS. 2-5 and 14, a pixel circuit group 120 is provided with a wiring area FF on at least one side along the first direction X. In an embodiment, the pixel circuit group 120 is provided with a wiring area FF on both sides along the first direction X. FIG. 24 shows a schematic diagram of a partial layout stacking of an active layer q, a metal layer M1 and a metal layer M2 in a display panel, in accordance with an embodiment of the present disclosure. It can be seen that the wiring area FF includes a signal line(s) 30 extending along the second direction Y, for example, a data signal line for transmitting a data signal to the pixel circuit 110, and a signal line for transmitting a driving signal to a driving circuit (driving the pixel circuit to work, including a multi-stage cascaded shift register circuit).

Different from the first shielding area CC, the wiring area FF is not provided with an active layer q. Therefore, the wiring area FF does not have to be completely covered by the physical part 10 of the first metal layer M3 and the physical part 20 of the second metal layer M4. That is, in the wiring area FF, in a direction perpendicular to the plane where the substrate is located, the openings 11 of the first metal layer M3 and the openings 21 of the second metal layer M3 may overlap. In an embodiment, as shown in FIG. 4, the openings 11 of the first metal layer M3 also includes a plurality of seventh openings K7, and the area of a seventh opening K7 is greater than the area of a first opening K1. In the wiring area FF, the seventh openings K7 are arranged along the second direction Y.

When the first metal layer M3 and the second metal layer M4 are set in the entire display area, due to the limitations of the actual process, such as the arc discharge that is prone to occur when a large area of metal is patterned in a vacuum machine, the area of the physical part 10 of the first metal layer M3 and the area of the physical part 20 of the second metal layer M4 will be subject to certain restrictions. In the first shielding area CC, in order to shield the active layer q, the openings 11 of the first metal layer M3 and the openings 21 of the second metal layer M4 are arranged in an alternating and complementary manner in a direction perpendicular to the plane where the substrate is located, so that the area of the physical part 10 of the first metal layer M3 and the area of the physical part 20 of the second metal layer M4 are still large. In a direction perpendicular to the plane where the substrate is located, the overlapping area of the physical part 10 of the first metal layer M3 and the physical part 20 of the second metal layer M4 is large, which is prone to short circuit, and thus the first metal layer M3 sets some seventh openings K7 with an area larger than the first opening K1 in the wiring area FF. The area of the physical part 10 of the first metal layer M3 may be reduced, and the overlapping area of the physical part 10 of the first metal layer M3 and the physical part 20 of the second metal layer M4 may be reduced. Moreover, the coupling between the physical part 10 of the first metal layer M3 (e.g., the first power structure PVDD) and the signal line(s) in the wiring area FF may also be reduced.

In an embodiment, as shown in FIG. 4, along the second direction Y, the seventh openings K7 and multiple first openings K1 are alternatingly arranged. That is, for the first metal layer M3 in the wiring area FF, between the seventh openings K7 adjacent to each other along the second direction Y, multiple first openings K1 are also provided. In this way, not only are some seventh openings K7 having an area larger than the first openings K1 provided on the first metal layer M3 in the wiring area FF, but a plurality of first openings K1 are also retained, so that the pattern density of the first metal layer M3 in the wiring area FF is relatively uniform with that in the first shielding area CC, which is beneficial to improving the etching uniformity of the display panel and the uniformity of the reflection effect.

It should be noted that, as shown in FIG. 4, a seventh opening K7 is larger than the area of a first opening K1. In an embodiment, the length of a seventh opening K7 along the first direction X is larger than the length of a first opening K1 along the first direction X. Thus, along the first direction X, a seventh opening K7 overlaps with multiple first openings K1. Alternatively, the width of the seventh opening K7 along the second direction Y is larger than the width of the first opening K1 along the second direction Y. Thus, along the second direction Y, a seventh opening K7 overlaps with multiple first openings K1. Alternatively, the length of a seventh opening K7 along the first direction X is larger than the length of the first opening K1 along the first direction X, and the width of the seventh opening K7 along the second direction Y is larger than the width of the first opening K1 along the second direction Y. Thus, along the first direction X and the second direction Y, a seventh opening K7 overlaps with multiple first openings K1. In summary, along the first direction X and/or the second direction Y, a seventh opening K7 overlaps with multiple first openings K1.

Similarly, in an embodiment, as shown in FIG. 5, the openings 21 of the second metal layer M4 also include a plurality of eighth openings K8, and the area of an eighth opening K8 is greater than the area of a second opening K2. In the wiring area FF, the eighth openings K8 are arranged along the second direction Y. That is, the second metal layer M4 is provided with some eighth openings K8 with an area greater than the area of a second opening K2 in the wiring area FF. This may reduce the area of the physical part 20 of the second metal layer M4, and reduce the overlapping area between the physical part 10 of the first metal layer M3 and the physical part 20 of the second metal layer M4, and may also reduce the coupling between the physical part 20 of the second metal layer M4 (e.g., the second power structure PVEE) and the signal line(s) in the wiring area FF.

In an embodiment, as shown in FIG. 5, along the second direction Y, the eighth openings K8 and multiple second openings K2 are alternately arranged. That is, for the second metal layer M4 in the wiring area FF, between the eighth openings K8 adjacent to each other along the second direction Y, multiple second openings K2 are also provided. In this way, not only are some eighth openings K8 having an area larger than the second openings K2 provided in the wiring area FF, but the plurality of second openings K2 are also retained, so that the pattern density of the second metal layer M4 in the wiring area FF is relatively uniform with the pattern density in the first shielding area CC, which is beneficial to improving the etching uniformity of the display panel and the uniformity of the reflection effect.

It should be noted that, as shown in FIG. 5, an eighth opening K8 is larger than the area of a second opening K2. In an embodiment, the length of an eighth opening K8 along the first direction X is larger than the length of a second opening K2 along the first direction X. Thus, along the first direction X, an eighth opening K8 overlaps with multiple second openings K2. Alternatively, the width of an eighth opening K8 along the second direction Y is larger than the width of a second opening K2 along the second direction Y. Thus, along the second direction Y, an eighth opening K8 overlaps with multiple second openings K2. Alternatively, the length of an eighth opening K8 along the first direction X is larger than the length of a second opening K2 along the first direction X, and the width of the eighth opening K8 along the second direction Y is larger than the width of the second opening K2 along the second direction Y. Thus, along the first direction X and the second direction Y, the eighth opening K8 overlaps with multiple second openings K2. In summary, along the first direction X and/or the second direction Y, an eighth opening K8 overlaps with multiple second openings K2.

In an embodiment, referring to FIGS. 4, 5 and 14, while the seventh openings K7 are formed in the first metal layer M3, the eighth openings K8 are also formed in the second metal layer M4. That is, the openings 11 of the first metal layer M3 also include a plurality of seventh openings K7, and the area of a seventh opening K7 is larger than the area of a first opening K1. In the wiring area FF, the seventh openings K7 are arranged along the second direction Y. The openings 21 of the second metal layer M4 also include a plurality of eighth openings K8, and the area of an eighth opening K8 is larger than the area of a second opening K2. In the wiring area FF, the eighth openings K8 are arranged along the second direction Y. In an embodiment, the orthographic projections of eighth openings K8 on the first metal layer M3 are alternately arranged with the seventh openings K7 along the second direction Y. In this way, the area of the physical part 10 of the first metal layer M3 and the area of the physical part 20 of the second metal layer M4 may be reduced. At the same time, the overlapping area of the physical part 10 of the first metal layer M3 and the physical part 20 of the second metal layer M4 may be reduced. The coupling between the physical part 10 of the first metal layer M3 (e.g., the first power structure PVDD) and the signal line(s) in the wiring area FF, and the coupling between the physical part 20 of the second metal layer M4 (e.g., the second power structure PVEE) and the signal line(s) in the wiring area FF may also be reduced.

Further, in an embodiment, referring to FIGS. 4, 5 and 14, in the wiring area FF, along the second direction Y, the seventh openings K7 and multiple first openings K1 are alternately arranged. Along the second direction Y, the eighth openings K8 and multiple second openings K2 are alternately arranged. In an embodiment, the orthographic projection of an eighth opening K8 on the first metal layer M3 overlaps with multiple first openings K1 between two adjacent seventh openings K7. Alternatively, the orthographic projection of a seventh opening K7 on the second metal layer M4 overlaps with multiple second openings K2 between two adjacent eighth openings K8. Alternatively, the orthographic projection of an eighth opening K8 on the first metal layer M3 overlaps with multiple first openings K1 between two adjacent seventh openings K7, and the orthographic projection of a seventh opening K7 on the second metal layer M4 overlaps with multiple second openings K2 between two adjacent eighth openings K8.

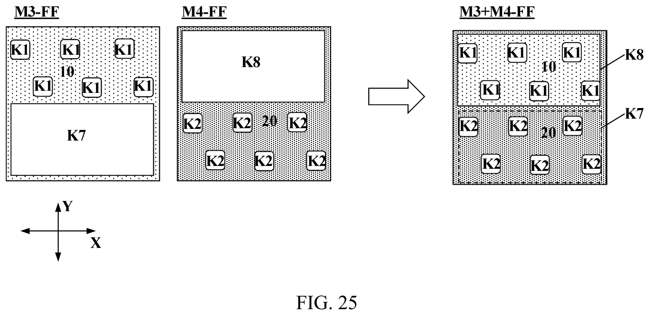

For a better understanding, FIG. 25 shows a schematic diagram of a partially enlarged view of the first metal layer M3 and the second metal layer M4 in the wiring area FF. It can be seen that in the wiring area FF, the orthographic projection of an eighth opening K8 on the first metal layer M3 and the seventh opening K7 are arranged in an alternating and complementary manner. The orthographic projection of an eighth opening K8 on the first metal layer M3 overlaps with multiple first openings K1 between two adjacent seventh openings K7. The orthographic projection of a seventh opening K7 on the second metal layer M4 overlaps with multiple second openings K2 between two adjacent eighth openings K8.

It may be understood that the orthographic projection of an eighth opening K8 on the first metal layer M3 overlaps with multiple first openings K1 between two adjacent seventh openings K7, and/or the orthographic projection of a seventh opening K7 on the second metal layer M4 overlaps with multiple second openings K2 between two adjacent eighth openings K8. This may further reduce the overlapping area of the physical part 10 of the first metal layer M3 and the physical part 20 of the second metal layer M4, and may also further reduce the coupling between the physical part 10 of the first metal layer M3 (e.g., the first power structure PVDD) and the signal line(s) in the wiring area FF, and the coupling between the physical part 20 of the second metal layer M4 (e.g., the second power structure PVEE) and the signal line(s) in the wiring area FF. The pattern density of the first metal layer M3 in the wiring area FF is relatively uniform with the pattern density in the first shielding area CC, and the pattern density of the second metal layer M4 in the wiring area FF is also relatively uniform with the pattern density in the first shielding area CC, which is beneficial to improving the etching uniformity of the display panel and the uniformity of the reflection effect.

The above embodiments have explained how to design the openings 11 of the first metal layer M3 and the openings 21 of the second metal layer M4 in the first shielding area CC and the wiring area FF. As already known, the display panel includes a display area, and the first shielding area CC and the wiring area FF are both located in the display area. When the physical part 10 of the first metal layer M3 (e.g., the first power structure PVDD) and the physical part 20 of the second metal layer M4 (e.g., the second power structure PVEE) are set in the entire display area, as shown in FIGS. 4 and 5, in other areas of the display area except the first shielding area CC and the wiring area FF, the first metal layer M3 and the second metal layer M4 may also be provided with openings to further reduce the area of the physical part 10 of the first metal layer M3 and the area of the physical part 20 of the second metal layer M4. This further reduces the overlapping area of the physical part 10 of the first metal layer M3 and the physical part 20 of the second metal layer M4, thereby reducing the risk of short circuit between the physical part 10 of the first metal layer M3 and the physical part 20 of the second metal layer M4. It may be understood that, similar to the wiring area FF, in the area where the thin film transistor is not provided in the display area, the openings 11 of the first metal layer M3 and the openings of the second metal layer M4 may overlap in a direction perpendicular to the plane where the substrate is located.

Moreover, in other areas of the display area except the first shielding area CC and the wiring area FF, the openings 11 of the first metal layer M3 and the openings of the second metal layer M4 may be evenly arranged, which is beneficial to improving the etching uniformity and the uniformity of the reflection effect of the display panel.

In an embodiment, in other areas of the display area except the first shielding area CC and the wiring area FF, the openings of the first metal layer M3 may be the first openings K1, which are arranged the same as the first openings K1 in the first shielding area CC and the wiring area FF, and the openings of the second metal layer M4 may be the second openings K2, which are arranged the same as the second openings K2 in the first shielding area CC and the wiring area FF. In this way, in the entire display area, the pattern density of the openings of the first metal layer M3 is relatively uniform, and the pattern density of the openings of the second metal layer M4 is also relatively uniform, which may improve the etching uniformity of the display panel and the uniformity of the reflection effect.

It may be understood that, the present disclosure forms a plurality of openings 11 in the first metal layer M3 to reduce the area of the physical part 10 of the first metal layer M3, and forms a plurality of openings 21 in the second metal layer M4 to reduce the area of the physical part 20 of the first metal layer M4. In a direction perpendicular to the plane where the substrate is located, the openings 11 of the first metal layer M3 and the openings 21 of the second metal layer M4 are arranged in an alternating and complementary manner as a whole to reduce the overlapping area of the physical part 10 of the first metal layer M3 and the physical part 20 of the first metal layer M4. However, due to the fact that the physical part 10 of the first metal layer M3 may be set on the entire display area, and the physical part 20 of the second metal layer may also be set on the entire display area, most of the physical part 10 of the first metal layer M3 serves as the first power structure PVDD, which still increases the area of the first power structure PVDD, and most of the physical part 20 of the second metal layer M4 serves as the second power structure PVEE, which still increases the area of the second power structure PVEE. Therefore, the impedance of the first power structure PVDD and the impedance of the second power structure PVEE are still greatly reduced, thereby greatly improving the brightness uniformity of the display panel.

In an embodiment, the area of the physical part 10 of the first metal layer M3 accounts for a proportion of the total area of the display area in the range of 50%-70%, including the endpoint values. The area of the physical part 20 of the second metal layer M4 accounts for a proportion of the total area of the display area in the range of 50%-70%, including the endpoint values. It may be understood that compared with the first power structure PVDD using a grid line distribution and the second power structure PVEE using a grid line distribution in the existing technologies, the area of the physical part 10 of the first metal layer M3 is larger, so as to increase the area of the first power structure PVDD. Similarly, the area of the physical part 20 of the second metal layer M4 is larger, so as to increase the area of the second power structure PVEE. This then improves the brightness uniformity of the display panel.

The above embodiments are mainly described by taking the first shielding area CC including the pixel circuits 110 and the first active portions q1 of the pixel circuit groups 120 as an example.

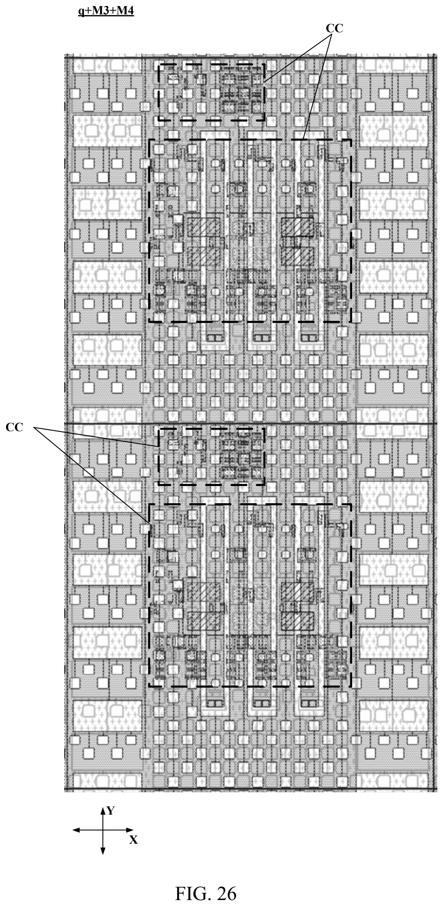

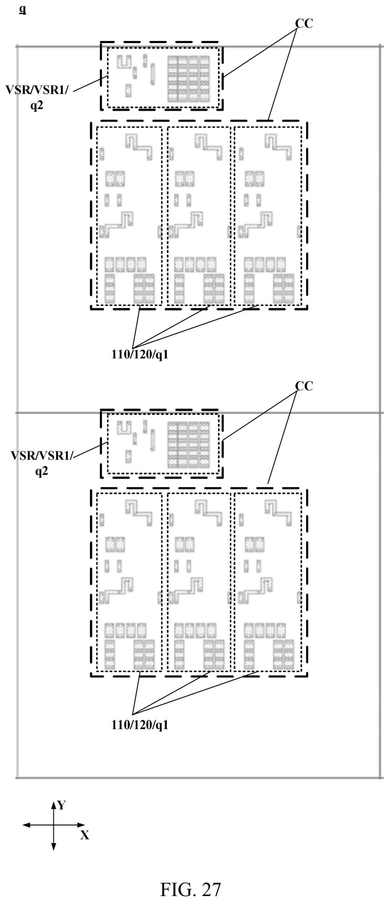

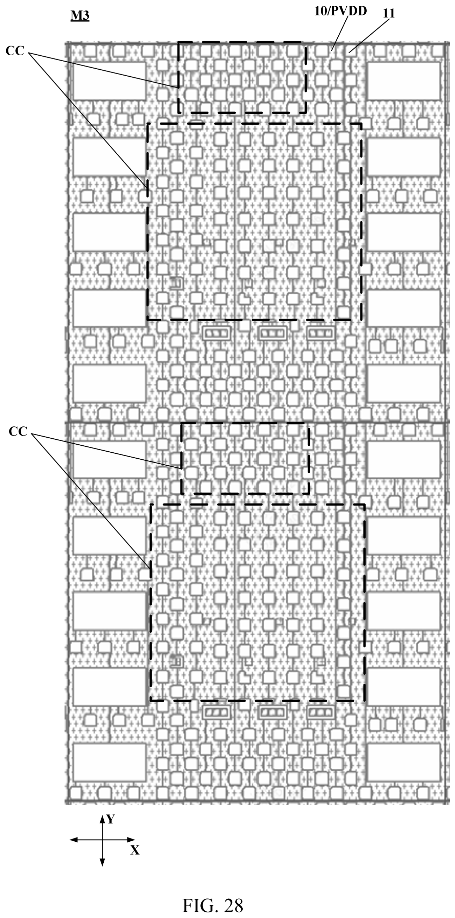

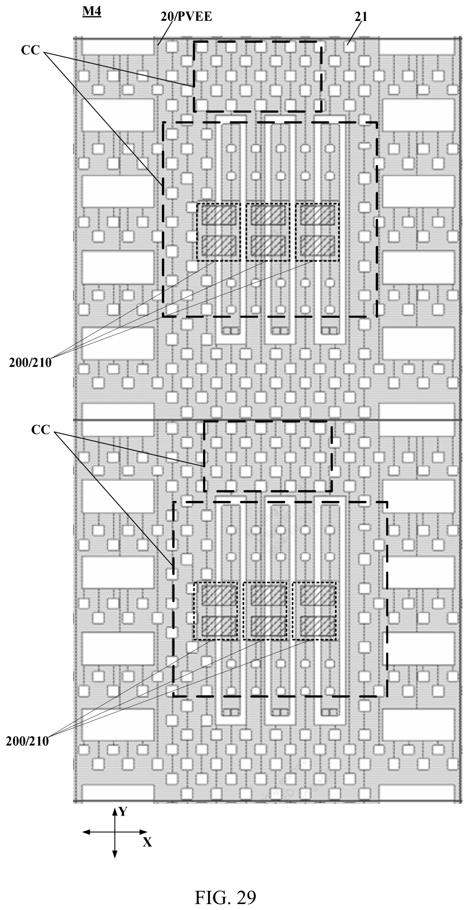

Referring to FIGS. 26 to 29, FIG. 26 shows a schematic diagram of a partial layout structure of an active layer q, a first metal layer M3 and a second metal layer M4 in another display panel, in accordance with an embodiment of the present disclosure. For clarity, FIG. 27 shows a schematic diagram of the layout structure of the active layer q in FIG. 26, FIG. 28 shows a schematic diagram of the layout structure of the first metal layer M3 in FIG. 27, and FIG. 29 shows a schematic diagram of the layout structure of the second metal layer M4 in FIG. 27. It can be seen that the display panel includes a driving circuit VSR, and the driving circuit VSR includes a multi-stage cascaded shift register circuit VSR1. The shift register circuit VSR1 also includes at least one thin film transistor, and the active portion of the thin film transistor in the shift register circuit VSR1 also needs to be shielded to prevent the active portion of the thin film transistor in the shift register circuit VSR1 from being affected when laser bonding the light emitting diode.

Based on this, as shown in FIG. 27, the active layer q includes a second active portion q2, the shift register circuit VSR1 includes the second active portion q2, the second active portion q2 includes an active portion of each thin film transistor in the shift register circuit VSR1, and the second active portion q2 is also located in the first shielding area CC. That is, the active portion of each thin film transistor in the shift register circuit VSR1 is located in the first shielding area CC, so that, in a direction perpendicular to the plane where the substrate is located, at least one of the physical part 10 of the first metal layer M3 and the physical part 20 of the second metal layer M4 covers the first shielding area CC, that is, covers the first active portion q1 of the pixel circuit 110 while also covering the second active portion q2 of the shift register circuit VSR1, thereby avoiding affecting the first active portion q1 of the pixel circuit 110 and the second active portion q2 of the shift register circuit VSR1 when laser bonding the light emitting diode.

It should be noted that in the present disclosure, for clarity of illustration, some drawings such as FIG. 27 use the second active portion q2 in the shift register circuit VSR1 to represent the shift register circuit VSR1. It may be understood that the shift register circuit VSR1 also includes other film layer structures, which will not be repeated here.

It may be understood that the designs of the openings of the first metal layer M3 and the openings of the second metal layer M4 in the first shielding area CC including the first active portion q1 of the pixel circuit 110 in the aforementioned embodiments are also applicable to the first shielding area CC including the second active portion q2 of the shift register circuit VSR1. Therefore, for the first shielding area CC including the second active portion q2 of the shift register circuit VSR1, the designs of the openings of the first metal layer M3 and the openings of the second metal layer M4 may refer to the aforementioned embodiments and will not be repeated here.

On the basis of the above embodiments, in an embodiment, as shown in FIG. 27, the shift register circuit VSR1 may be located between pixel circuits 110. That is, by compressing some pixel circuits 110 in the display area and setting the shift register circuit VSR1 in the display area, it is beneficial to realize a borderless, full-screen design of the display panel, and may be applied to a spliced display device.

Alternatively, similar to the pixel circuits 110, the shift register circuit VSR1 is also typically disposed in the array substrate, and is composed of an active layer q, a metal layer M1, and a metal layer M2, and the light emitting diodes 200 are located on the array substrate 100. Therefore, even if the driving circuit VSR including a multi-stage cascaded shift register circuit VSR1 is disposed on one or both sides of the display area along the first direction X, the shift register circuit VSR1 and the light emitting diodes 200 may be arranged to overlap in a direction perpendicular to the plane of the substrate. At this moment, the light emitting diodes overlapping with the shift register circuit VSR1 may not overlap with the electrically connected pixel circuits 110. In this way, a borderless, full-screen design of the display panel may be realized, and it may be applied to a spliced display device.

It may be understood that in the display panels provided in the embodiment of the present disclosure, as long as a thin film transistor is in the display area, it is necessary to be covered by at least one of the physical part 10 of the first metal layer M3 and the physical part 20 of the second metal layer M4 to prevent the active portion of the thin film transistor from being affected when the laser bonding of the light emitting diode occurs. Therefore, in addition to the first active portions q1 of the pixel circuits 110 and the second active portion q2 of the shift register circuit VSR1, the first shielding area CC may also include active layers in circuits such as an electrostatic discharge (ESD) circuit and a demultiplexer (Demux) circuit, which are not described one by one.

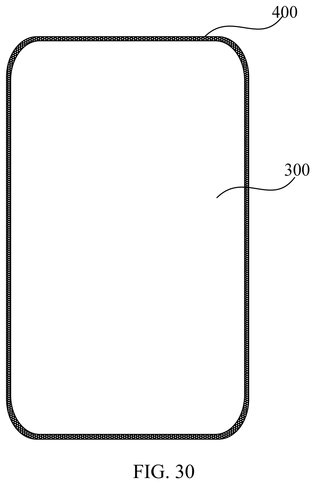

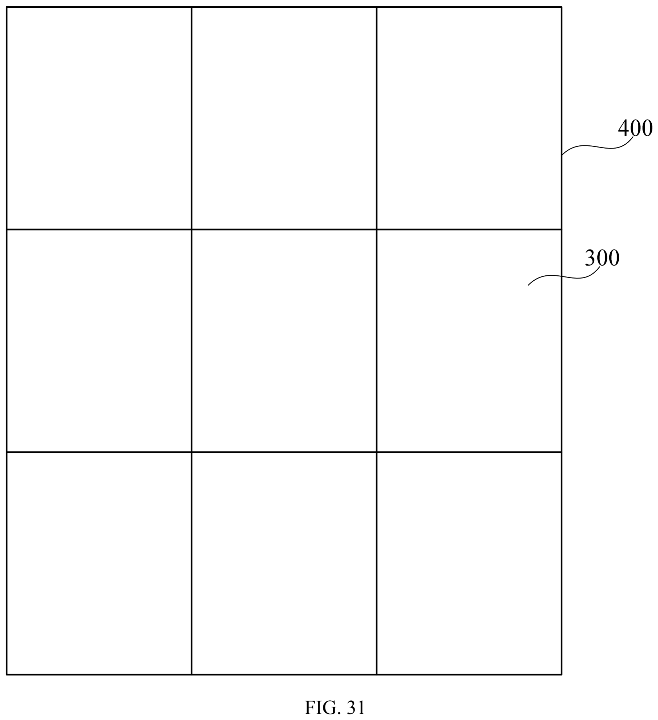

The embodiments of the present disclosure further provide a display device. As shown in FIGS. 30 and 31, the display device 400 includes the display panel 300 provided by any of the above embodiments. Since the display panel 300 has been described in detail in the above embodiments, it will not be repeated here.

The display device 400 may be any electronic device with a display function, such as a touch screen, a mobile phone, a tablet computer, a notebook computer, an e-reader, or a television.

It should be noted that, since in the aforementioned embodiments, setting the driving circuit VSR in the display area may realize a borderless, full-screen design of the display panel 300, the display device provided in the embodiments of the present disclosure may be a spliced display device, including multiple borderless display units (i.e., the display panel 300).

Compared with the existing technologies, the above technical solution has the following advantages:

The display panel provided by the embodiments of the present disclosure includes a substrate, an active layer located on one side of the substrate, and multiple metal layers located on the side of the active layer away from the substrate. The multiple metal layers include a first metal layer and a second metal layer. The display panel includes a first shielding area, and at least part of the active layer is located in the first shielding area. In a direction perpendicular to the plane where the substrate is located, at least one of the physical part of the first metal layer and the physical part of the second metal layer covers the first shielding area, thereby covering the active layer in the first shielding area, so as to avoid affecting the active layer in the first shielding area when laser bonding the light emitting diode, thereby avoiding affecting the performance of the thin film transistor including the active layer in the first shielding area.

Furthermore, considering that in actual processes, arc discharge is prone to occur when a large area of metal is placed in a vacuum machine for patterning, the area of the physical part of the first metal layer and the area of the physical part of the second metal layer are subject to certain restrictions. Furthermore, considering that in a direction perpendicular to the plane where the substrate is located, if the overlapping area of the physical part of the first metal layer and the physical part of the second metal layer is large, a short circuit between the first metal layer and the second metal layer may be easily caused when the insulating layer between the first metal layer and the second metal layer is damaged. Therefore, a plurality of openings are formed in the first metal layer to reduce the area of the physical part of the first metal layer, and a plurality of openings are formed in the second metal layer to reduce the area of the physical part of the second metal layer, thereby reducing the risk of arc discharge when the first metal layer and the second metal layer are placed in a vacuum machine for patterning. The overlapping area of the physical part of the first metal layer and the physical part of the second metal layer in a direction perpendicular to the plane where the substrate is located may also be reduced, thereby reducing the risk of a short circuit between the first metal layer and the second metal layer when the insulating layer between the first metal layer and the second metal layer is damaged.

The various parts in this specification are described in a combination of parallel and progressive ways. Each part focuses on the differences from other parts, and the same or similar parts between the various parts may be referenced to each other.

With respect to the above description of the disclosed embodiments, the features described in the embodiments in this specification may be replaced or combined with each other, so that a person skilled in the art may implement or use the present disclosure. Various modifications to these embodiments will be apparent to a person skilled in the art, and the general principles defined herein may be implemented in other embodiments without departing from the scope of the present disclosure. Therefore, the present disclosure will not be limited to the embodiments shown herein, but will conform to the widest scope consistent with the principles and novel features disclosed herein.

**Claims**

1. A display panel, **characterized by** comprising:

    a substrate;
    an active layer located on a side of the substrate; and
    multiple metal layers located on a side of the active layer away from the substrate, the multiple metal layers comprising a first metal layer and a second metal layer, the first metal layer comprising a physical part and a plurality of openings of the first metal layer, the second metal layer comprising a physical part and a plurality of openings of the second metal layer;

wherein the display panel comprises a first shielding area, at least a portion of the active layer is located within the first shielding area, and in a direction perpendicular to a plane where the substrate is located, at least one of the physical part of the first metal layer and the physical part of the second metal layer covers the first shielding area.

2. The display panel according to claim 1, wherein an insulating layer is provided between the first metal layer and the second metal layer, and the insulating layer is an organic material layer.

3. The display panel according to claim 1, further comprising:

a plurality of pixel circuits;
wherein the active layer comprises a first active portion, the plurality of pixel circuits comprises the first active portion, and the first active portion is located within the first shielding area.

4. The display panel according to claim 3, wherein:

the physical part of the first metal layer comprises a first power supply structure, and the first power supply structure is configured to provide a first power supply voltage;
the physical part of the second metal layer comprises a second power supply structure, and the second power supply structure is configured to provide a second power supply voltage; and
the display panel comprises a plurality of light emitting diodes, the first power supply structure is electrically connected to the plurality of pixel circuits, the plurality of pixel circuits is electrically connected to first electrodes of the plurality of light emitting diodes, and the second power supply structure is electrically connected to second electrodes of the plurality of light emitting diodes.

5. The display panel according to claim 4, wherein a pixel circuit of the plurality of pixel circuits comprises a pulse width module and an amplitude module, and the first power supply structure is electrically connected to the amplitude module of the pixel circuit of the plurality of pixel circuits.

6. The display panel according to claim 4, wherein:

at least two pixel circuits of the plurality of pixel circuits form a pixel circuit group, and first active portions of the pixel circuit group are located in the first shielding area;
the pixel circuit group is arranged in rows along a first direction, and a plurality of rows of pixel circuit groups are arranged along a second direction, the first direction and the second direction intersect, and the first direction and the second direction are parallel to the plane where the substrate is located;
in the direction perpendicular to the plane where the substrate is located, the first power supply structure at least partially overlaps with four pixel circuit groups comprising two adjacent rows of pixel circuit groups and two adjacent columns of pixel circuit groups of the first power supply structure; and
in the direction perpendicular to the plane where the substrate is located, the second power supply structure at least partially overlaps with four pixel circuit groups comprising two adjacent rows of pixel circuit groups and two adjacent columns of pixel circuit groups the second power supply structure.

7. The display panel according to claim 6, wherein:

the plurality of openings of the first metal layer comprises a plurality of first openings;
the plurality of openings of the second metal layer comprises a plurality of second openings; and
in the first shielding area, first openings of the plurality of first openings and second openings of the plurality of second openings do not overlap in the direction perpendicular to the plane where the substrate is located.

8. The display panel according to claim 7, wherein:

in at least a portion of the first shielding area, first openings of the plurality of first openings are arranged in columns along the second direction, a plurality of columns of first openings of the plurality of first openings are arranged along the first direction, first openings of the plurality of first openings in alternate columns overlap along the first direction, and first openings of the plurality of first openings in adjacent columns overlap along the first direction or the first openings of the plurality of first openings in adjacent columns at least partially do not overlap along the first direction; and/or
in at least a portion of the first shielding area, second openings of the plurality of second openings are arranged in columns along the second direction, a plurality of columns of the second openings of the plurality of second openings are arranged along the first direction, second openings of the plurality of second openings in alternate columns overlap along the first direction, and second openings of the plurality of second openings in adjacent columns overlap along the first direction or the second openings of the plurality of second openings in adjacent columns at least partially do not overlap along the first direction.

9. The display panel according to claim 7, wherein:

in at least a portion of the first shielding area, first openings of the plurality of first openings are arranged in columns along the second direction, a plurality of columns of first openings of the plurality of first openings are arranged along the first direction, first openings of the plurality of first openings in adjacent columns overlap along the first direction, and first openings of the plurality of first openings in alternate columns overlap along the first direction; and/or
in at least a portion of the first shielding area, second openings of the plurality of second openings are arranged in columns along the second direction, a plurality of columns of second openings of the plurality of second openings are arranged along the first direction, second openings of the plurality of second openings in adjacent columns overlap along the first direction, and second openings of the plurality of second openings in alternate columns overlap along the first direction.

10. The display panel according to claim 7, wherein:

the physical part of the second metal layer further comprises a first auxiliary electrode, and a third opening is provided between the first auxiliary electrode and the second power structure;
the first auxiliary electrode is electrically connected to the plurality of pixel circuits, and the first auxiliary electrode is electrically connected to the first electrodes of the plurality of light emitting diodes; and
the first auxiliary electrode and a second power structure between two adjacent first auxiliary electrodes are provided with a plurality of fourth openings, and an area of a fourth opening of the plurality of fourth openings is smaller than an area of a second opening of the plurality of second openings.

11. The display panel according to claim 10, wherein:

in the direction perpendicular to the plane where the substrate is located, a plurality of fifth openings are provided at a portion where the first power structure overlaps with the first auxiliary electrode and the second power structure between two adjacent first auxiliary electrodes;
the plurality of fifth openings are arranged in columns along the second direction, a plurality of columns of fifth openings of the plurality of fifth openings are arranged along the first direction, fifth openings of the plurality of fifth openings in adjacent columns overlap along the first direction, and fifth openings of the plurality of fifth openings in alternate columns overlap along the first direction; and
orthographic projections of the fourth openings of the plurality of fourth openings on the first metal layer are alternately arranged with the fifth openings of the plurality of fifth openings along the second direction.

12. The display panel according to claim 10, wherein:

the physical part of the first metal layer further comprises a second auxiliary electrode, and a sixth opening is provided between the second auxiliary electrode and the first power structure; and
in the direction perpendicular to the plane where the substrate is located, the first auxiliary electrode and the second auxiliary electrode at least partially overlap, the first auxiliary electrode and the second auxiliary electrode are electrically connected, and the second auxiliary electrode is electrically connected to the plurality of pixel circuits.

13. The display panel according to claim 12, wherein:

the sixth opening is located outside the first shielding area; or
the sixth opening is located within the first shielding area, and in the direction perpendicular to the plane where the substrate is located, the sixth opening does not overlap with the active layer.

14. The display panel according to claim 12, wherein:

at least two light emitting diodes of the plurality of light emitting diodes form a light emitting element group, and one pixel circuit group is electrically connected to one light emitting element group;

in the direction perpendicular to the plane where the substrate is located, the pixel circuit group and a light emitting element group electrically connected with the pixel circuit group at least partially do not overlap along the second direction; and

in the direction perpendicular to the plane where the substrate is located, the first auxiliary electrode and the second auxiliary electrode overlap in the first shielding area, the second auxiliary electrode and the sixth opening are at least partially located outside the first shielding area, and the sixth opening does not overlap with the active layer.

15. The display panel according to claim 4, wherein:

the first power structure comprises a first connection portion, and the first connection portion is electrically connected to the plurality of pixel circuits; and

at least a portion of the first connecting portion protrudes toward an opening of the first metal layer.

16. The display panel according to claim 1, wherein in the first shielding area, a minimum distance d between an orthographic projection of an opening of the second metal layer on the first metal layer and an opening of the first metal layer satisfies:

$$d \geq \frac{X1 + X2}{2} + \sqrt{Y^2 + H^2} \ ,$$

wherein, X1 is a line width difference between a design pattern and an actual production pattern of the first metal layer, X2 is a line width difference between a design pattern and an actual production pattern of the second metal layer, Y is a fitting accuracy between the first metal layer and the second metal layer, and H is a thickness of the insulating layer between the first metal layer and the second metal layer.

17. The display panel according to claim 7, wherein:

a wiring area is provided on at least one side of the pixel circuit group along the first direction, and the wiring area comprises a signal line extending along the second direction;

the plurality of openings of the first metal layer further comprises a plurality of seventh openings, and an area of a seventh opening of the plurality of seventh openings is greater than an area of a first opening of the plurality of first openings; and

in the wiring area, the plurality of seventh openings are arranged along the second direction.

18. The display panel according to claim 17, wherein along the second direction, the plurality of seventh openings and the plurality of first openings are alternatingly arranged.

19. The display panel according to claim 7, wherein:

a wiring area is provided on at least one side of the pixel circuit group along the first direction, and the wiring area comprises a signal line extending along the second direction;

the plurality of openings of the second metal layer further comprises a plurality of eighth openings, and an area of an eighth opening of the plurality of eighth openings is greater than an area of a second opening of the plurality of second openings; and

in the wiring area, the plurality of eighth openings are arranged along the second direction.

20. The display panel according to claim 19, wherein along the second direction, the plurality of eighth openings and the plurality of the second openings are alternatingly arranged.

21. The display panel according to claim 7, wherein:

a wiring area is provided on at least one side of the pixel circuit group along the first direction, and the wiring area comprises a signal line extending along the second direction;

the plurality of openings of the first metal layer further comprises a plurality of seventh openings, and an area of a seventh opening of the plurality of seventh openings is greater than an area of a first opening of the plurality of first openings;

in the wiring area, the plurality of seventh openings are arranged along the second direction;

the plurality of openings of the second metal layer further comprises a plurality of eighth openings, an area of an eighth opening of the plurality of eighth openings is greater than an area of a second opening of the plurality of second openings;

in the wiring area, the plurality of eighth openings are arranged along the second direction;

orthographic projections of the plurality of eighth openings on the first metal layer and the plurality of seventh openings are alternatingly arranged along the second direction.

22. The display panel according to claim 21, wherein:

along the second direction, the plurality of seventh openings and the plurality of first openings are alternatingly arranged;

along the second direction, the plurality of eighth openings and the plurality of the second openings are alternatingly arranged; and

an orthographic projection of an eighth opening of the plurality of eighth openings on the first metal layer overlaps with a plurality of first openings between two adjacent seventh openings of the plurality of seventh openings, and/or an orthographic projection of a seventh opening of the plurality of seventh openings on the second metal layer overlaps with a plurality of second openings between two adjacent eighth openings of the plurality of eighth openings.

23. The display panel according to claim 1, wherein:

the display panel comprises a driving circuit, and the driving circuit comprises a multi-stage cascaded shift register circuit; and

the active layer comprises a second active portion, the shift register circuit comprises the second active portion, and the second active portion is located within the first shielding area.

24. The display panel according to claim 23,

wherein the display panel comprises a plurality of pixel circuits, and the shift register circuit is located between the plurality of pixel circuits, or

wherein the display panel comprises a plurality of light emitting diodes, and in the direction perpendicular to the plane where the substrate is located, the shift register circuit and the plurality of light emitting diodes overlap.

25. A display device, **characterized by** comprising the display panel according to any one of claims 1 to 24.

<u>100</u>

FIG. 1

FIG. 2

q

CC

q1

110/120

Y

X

FIG. 3

FIG. 4

FIG. 5

FIG. 6

FIG. 7

FIG. 8

FIG. 9

**q+M3+M4**

FIG. 10

**q**

pixel

CC

110/120

Y

X

FIG. 11

FIG. 12

FIG. 13

FIG. 14

FIG. 15

FIG. 16

**q+M3+M4**

FIG. 17

FIG. 18

FIG. 19

FIG. 20

FIG. 21

W1

M4 PLN
M3

W1'

FIG. 22a

W2

M4 PLN
M3

W2'

FIG. 22b

M4
PLN
M3

FIG. 23a

M4
PLN
M3

FIG. 23b

q+M1+M2

FF

FF

30

30

CC

110/120

FIG. 24

FIG. 25

**q+M3+M4**

FIG. 26

q

CC

VSR/VSR1/
q2

110/120/q1

CC

VSR/VSR1/
q2

110/120/q1

Y

X

FIG. 27

FIG. 28

FIG. 29

FIG. 30

400

300

FIG. 31

**EUROPEAN SEARCH REPORT**

Application Number

EP 25 21 2419

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CN 114 937 436 A (XIAMEN TIANMA DISPLAY TECH CO LTD) 23 August 2022 (2022-08-23) <br> * abstract *; claims 1-29; figures 1, 2, 29 * <br> * paragraph [0005] - paragraph [0013] * <br> * paragraph [0175] - paragraph [0191] * <br> ----- | 1-25 | INV. <br> H10D86/40 <br> H10D86/60 <br> H10K59/131 <br> G09G3/32 |
| A | CN 116 435 316 A (WUHAN TIANMA MICRO ELECTRONICS CO LTD) 14 July 2023 (2023-07-14) <br> * abstract *; claims 1-21; figures 1-14 * <br> * paragraph [0064] - paragraph [0132] * <br> * paragraph [0274] - paragraph [0280] * <br> ----- | 1-25 | |
| A | CN 115 050 340 A (XIAMEN TIANMA DISPLAY TECH CO LTD) 13 September 2022 (2022-09-13) <br> * abstract *; claims 1-21; figures 1-16 * <br> * paragraph [0005] - paragraph [0011] * <br> * paragraph [0051] - paragraph [0065] * <br> ----- | 1-25 | |

TECHNICAL FIELDS
SEARCHED (IPC)

H10D
H10K
G09G

The present search report has been drawn up for all claims

| Place of search | Date of completion of the search | Examiner |
|---|---|---|
| Berlin | 18 March 2026 | Hamdani, Fayçal |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
........................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 21 2419

This annex lists the patent family members relating to the patent documents cited in the above-mentioned European search report.
The members are as contained in the European Patent Office EDP file on
The European Patent Office is in no way liable for these particulars which are merely given for the purpose of information.

18-03-2026

| Patent document cited in search report | | Publication date | Patent family member(s) | | Publication date |
|---|---|---|---|---|---|
| CN 114937436 | A | 23-08-2022 | CN | 114937436 A | 23-08-2022 |
| | | | US | 2023042146 A1 | 09-02-2023 |
| CN 116435316 | A | 14-07-2023 | CN | 116435316 A | 14-07-2023 |
| | | | US | 2024006574 A1 | 04-01-2024 |
| CN 115050340 | A | 13-09-2022 | CN | 115050340 A | 13-09-2022 |
| | | | CN | 120548065 A | 26-08-2025 |
| | | | US | 2023015666 A1 | 19-01-2023 |
| | | | US | 20260026224 A1 | 22-01-2026 |

For more details about this annex : see Official Journal of the European Patent Office, No. 12/82